# EUROPEAN PATENT SPECIFICATION

(11) **EP 2 016 625 B1**
(45) Date of publication and mention of the grant of the patent: **02.09.2009**
(21) Application number: 07755589.4
(22) Date of filing: 18.04.2007
(51) Int. Cl.: H01L 31/0336, H01L 31/032, H01L 31/072, C08L 83/04

(54) **COPPER INDIUM DISELENIDE-BASED PHOTOVOLTAIC DEVICE AND METHOD OF PREPARING THE SAME**
FOTOVOLTAISCHE ANORDNUNG AUF KUPFER-INDIUM-DISELENIDBASIS UND HERSTELLUNGSVERFAHREN DAFÜR
DISPOSITIF PHOTOVOLTAIQUE A BASE DE DISELENIURE DE CUIVRE ET D'INDIUM ET PROCEDE DE PREPARATION DE CELUI-CI

(30) Priority: 18.04.2006 US 792871 P; 18.04.2006 US 792852 P
(43) Date of publication of application: 21.01.2009
(73) Proprietor: Dow Corning Corporation, Midland, Michigan 48686-0994 (US); ITN Energy Systems, INC., Littleton CO 80127-4107 (US)
(72) Inventor: ANDERSON, Nicole R., Midland, MI 48640 (US); KATSOULIS, Dimitris Elias, Midland, MI 48642 (US); REESE, Herschel Henry, Midland, MI 48640 (US); ZHU, Bizhong, Midland, MI 48640 (US); WOODS, Lawrence M., Littleton, CO 80127 (US); ARMSTRONG, Joseph H., Littleton, CO 80128 (US); RIBELIN, Rosine M., Lakewood, CO 80228 (US)
(74) Representative: Neilson, Martin Mark
(86) International application number: PCT/US2007/009365
(87) International publication number: WO 2007/123901

(56) References cited:
- EP-A- 1 388 572
- EP-A- 1 489 666
- EP-A2- 1 207 188
- WO-A-20/05052078
- US-A1- 2005 061 437

## Description

### FIELD OF THE INVENTION

The present invention generally relates to a copper indium diselenide-based photovoltaic device and a method of preparing the photovoltaic device. More specifically, the invention relates to a photovoltaic device that includes a polymeric substrate.

### BACKGROUND OF THE INVENTION

Copper indium diselenide (CIS)-based photovoltaic devices are well known for generating electricity from sunlight and other sources of light. The CIS-based photovoltaic devices are useful for providing electricity for any application in which the devices are exposed to the source of light. As a result, the potential applications for CIS-based photovoltaic devices are far-reaching.

To date, the CIS-based photovoltaic devices have been limited in the applications for which they may be used due to an inverse correlation between versatility and efficiency. More specifically, in order to be cost-effective, the photovoltaic devices must generate electricity at an efficiency that makes the cost-per-unit of electricity on par with or lower than traditional sources of electricity, such as batteries. In order to prepared CIS-based photovoltaic devices having suitable efficiency, the devices, which include a CIS or copper indium gallium diselenide (CIGS) layer on a substrate, are subjected to processing or annealing at temperatures in excess of 500°C, typically at a temperature of about 575 °C.

To date, few materials have proven useful for the substrate in the CIS-based photovoltaic devices due to an inability to sufficiently resist cracking and mechanical failure at the annealing temperatures in excess of 500 °C. Various types of glass are predominantly used as the substrate; however, glass adds weight to the devices and is typically rigid. The rigidity of the glass substrates renders the devices unsuitable for applications that require flexibility or applications in which the devices may be subjected to blunt force that could crack or otherwise damage the glass substrates. In addition to limiting potential applications for the devices, the glass substrates also require that the devices be individually prepared. More specifically, if a suitable flexible substrate were to be discovered, roll-to-roll preparation of the devices may be possible, which would greatly increase production efficiency and lower the costs of preparing the devices. A decrease in the weight of the substrate would also be advantageous for obvious reasons.

Certain flexible substrates formed from polyimide have been recently developed for use in CIS-based photovoltaic devices. The polyimide substrates eliminate the deficiencies of the glass substrates as to excessive weight and inflexibility; however, the polyimide substrates are prone to severe degradation at temperatures in excess of 425°C resulting in cracking and mechanical failure of devices. As such, the devices including the polyimide substrate cannot be properly formed to maximize efficiency of the devices.

Due to the deficiencies of the existing CIS-based photovoltaic devices including glass or polyimide substrates, there remains an opportunity to provide a CIS-based photovoltaic device including a substrate that is both flexible and sufficiently able to withstand annealing temperatures in excess of 500 °C to obtain maximum efficiency of the device.

Examples of such prior arrangements are described in EP 1489 666, which for the basis of claim 1, as well as WO 2005/052078; US 2005/061437; EP 1388572 and EP 1207188.

### SUMMARY OF THE INVENTION AND ADVANTAGES

According to the present invention there is therefore provided a copper indium diselenide (CIS)-based photovoltaic device as described in accompanying claim 1. There is also provided an array including a plurality of such devices. There is yet further provided a method of preparing a copper indium diselenide (CIS)-based photovoltaic device as further described in accompanying claim 15.

In an embodiment of the invention there is provided a copper indium diselenide (CIS)-based photovoltaic device and a method of preparing the same in which the CIS-based device includes a CIS-based solar absorber layer which is based on copper, indium; and selenium, and optionally includes alloys with aluminum, gallium and sulfur. The CIS-based photovoltaic device further includes a substrate formed from a silicone composition, and comprising a fiber reinforcement. The substrate, because it is formed from the silicone composition, is both flexible and sufficiently able to withstand annealing temperatures in excess of 500 °C to obtain maximum efficiency of the device.

### BRIEF DESCRIPTION OF THE FIGURES

Other advantages of the present invention will be readily appreciated, as the same becomes better understood by reference to the following detailed description when considered in connection with the accompanying drawings wherein:

Figure 1 is a photograph of a copper indium diselenide (CIS)-based photovoltaic device of the present invention;

Figure 2 is a top plan view of a copper indium diselenide (CIS)-based photovoltaic device of the present invention;

Figure 3 is a schematic of a substrate for a copper indium diselenide (CIS)-based photovoltaic device of the present invention, the substrate having a fiber reinforcement;

Figure 4 is a schematic cross-sectional side view of a copper indium diselenide (CIS)-based photovoltaic device of the present invention; and

Figure 5 is a schematic illustration of monolithic integration of copper indium diselenide (CIS)-based photovoltaic devices including a substrate having a fiber reinforcement.

### DETAILED DESCRIPTION OF THE PREFERRED EMBODIMENTS

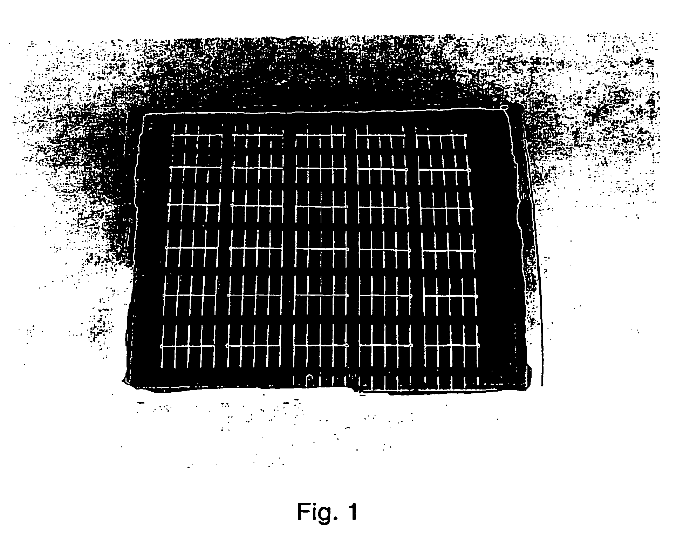

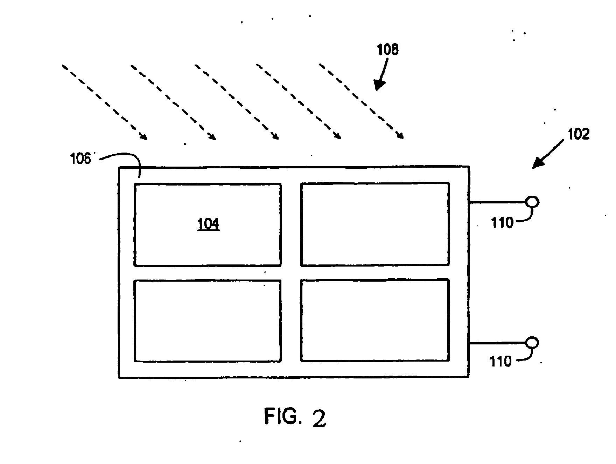

Referring to Figures 1 and 2, the present invention provides a copper indium diselenide (CIS)-based photovoltaic device **104** including a substrate **106** formed from a silicone composition. The CIS-based device **104** is operable to convert incident electromagnetic energy **108,** such as light, into an electric current. An array **102** may be provided including a plurality of the CIS-based photovoltaic devices **104.** In one embodiment, the CIS-based photovoltaic devices **104** are monolithically integrated onto the substrate **106** in the array **102.** The array **102** may be used to generate electric current from electromagnetic energy **108** which falls on the array **102.** The electric current generated by array **102,** which may be accessed via terminals **110,** may be used for a variety of purposes; for example, the array **102** may be used to provide electric power to spacecrafts or high altitude airships.

The silicone composition, once cured, provides the substrate **106** with flexibility and a sufficient ability to withstand annealing temperatures in excess of 500 °C without exhibiting substantial cracking. Further, the silicone composition, once cured, typically has a high electrical resistivity. As a result, CIS-based photovoltaic devices **104** may be prepared having maximized efficiency, as described in further detail below, and may further be used in non-planar applications due to the flexibility of the substrate **106.**

In one embodiment of the present invention, the silicone composition is further defined as a hydrosilylation-curable silicone composition including a silicone resin (A), an organosilicon compound (B), and a hydrosilylation catalyst (C). The silicone resin (A) has silicon-bonded alkenyl groups or silicon-bonded hydrogen atoms. The silicone resin (A) is typically a copolymer including R²SiO_{3/2} units, i.e., T units, and/or SiO_{4/2} units, i.e., Q units, in combination with R¹R²₂SiO_{1/2} units, i.e., M units, and/or R²₂SiO_{2/2} units, i.e., D units, wherein R¹ is a C₁ to C₁₀ hydrocarbyl group or a C₁ to C₁₀ halogen-substituted hydrocarbyl group, both free of aliphatic unsaturation, and R² is R¹, an alkenyl group, or hydrogen. For example, the silicone resin can be a DT resin, an MT resin, an MDT resin, a DTQ resin, an MTQ resin, an MDTQ resin, a DQ resin, an MQ resin, a DTQ resin, an MTQ resin, or an MDQ resin. As used herein, the term "free of aliphatic unsaturation" means the hydrocarbyl or halogen-substituted hydrocarbyl group does not contain an aliphatic carbon-carbon double bond or carbon-carbon triple bond.

The C₁ to C₁₀ hydrocarbyl group and C₁ to C₁₀ halogen-substituted hydrocarbyl group represented by R¹ more typically have from 1 to 6 carbon atoms. Acyclic hydrocarbyl and halogen-substituted hydrocarbyl groups containing at least 3 carbon atoms can have a branched or unbranched structure. Examples of hydrocarbyl groups represented by R¹ include, but are not limited to, alkyl groups, such as methyl, ethyl, propyl, 1-methylethyl, butyl, 1-methylpropyl, 2-methylpropyl, 1,1-dimethylethyl, pentyl, 1-methylbutyl, 1-ethylpropyl, 2-methylbutyl, 3-methylbutyl, 1,2-dimethylpropyl, 2,2-dimethylpropyl, hexyl, heptyl, octyl, nonyl, and decyl; cycloalkyl groups, such as cyclopentyl, cyclohexyl, and methylcyclohexyl; aryl groups, such as phenyl and naphthyl; alkaryl groups, such as tolyl and xylyl; and aralkyl groups, such as benzyl and phenethyl. Examples of halogen-substituted hydrocarbyl groups represented by R¹ include, but are not limited to, 3,3,3-trifluoropropyl, 3-chloropropyl, chlorophenyl, dichlorophenyl, 2,2,2-trifluoroethyl, 2,2,3,3-tetrafluoropropyl, and 2,2,3,3,4,4,5,5-octafluoropentyl.

The alkenyl groups represented by R², which may be the same or different within the silicone resin, typically have from 2 to 10 carbon atoms, alternatively from 2 to 6 carbon atoms, and are exemplified by, but are not limited to, vinyl, allyl, butenyl, hexenyl, and octenyl. In one embodiment, R² is predominantly the alkenyl group. In this embodiment, typically at least 50 mol%, alternatively at least 65 mol%, alternatively at least 80 mol%, of the groups represented by R² in the silicone resin are alkenyl groups. As used herein, the mol% of alkenyl groups in R² is defined as a ratio of the number of moles of silicon-bonded alkenyl groups in the silicone resin to the total number of moles of the R² groups in the resin, multiplied by 100. In another embodiment, R² is predominantly hydrogen. In this embodiment, typically at least 50 mol%, alternatively at least 65 mol%, alternatively at least 80 mol%, of the groups represented by R² in the silicone resin are hydrogen. The mol% of hydrogen in R² is defined as a ratio of the number of moles of silicon-bonded hydrogen in the silicone resin to the total number of moles of the R² groups in the resin, multiplied by 100.

According to a first embodiment, the silicone resin (A) has the formula:

(R¹R²₂SiO_{1/2})_{w}(R²₂SiO_{2/2})ₓ (R²SiO_{3/2})_{y}(SiO_{4/2})_{z} (I)

wherein R¹ and R² are as described and exemplified above and w, x, y, and z are mole fractions. Typically, the silicone resin represented by formula (I) has an average of at least two silicon-bonded alkenyl groups per molecule. More specifically, the subscript w typically has a value of from 0 to 0.9, alternatively from 0.02 to 0.75, alternatively from 0.05 to 0.3. The subscript x typically has a value of from 0 to 0.9, alternatively from 0 to 0.45, alternatively from 0 to 0.25. The subscript y typically has a value of from 0 to 0.99, alternatively from 0.25 to 0.8, alternatively from 0.5 to 0.8. The subscript z typically has a value of from 0 to 0.85, alternatively from 0 to 0.25, alternatively from 0 to 0.15. Also, the ratio y+z/(w+x+y+z) is typically from 0.1 to 0.99, alternatively from 0.5 to 0.95, alternatively from 0.65 to 0.9. Further, the ratio w+x/(w+x+y+z) is typically from 0.01 to 0.90, alternatively from 0.05 to 0.5, alternatively from 0.1 to 0.35.

When R² is predominantly the alkenyl group, specific examples of silicone resins represented by formula (I) above include, but are not limited to, resins having the following formulae: (Vi₂MeSiO_{1/2})_{0.25}(PhsiO_{3/2})_{0.75}, (ViMe₂SiO_{1/2})_{0.25}(PhSiO_{3/2})_{0.75}, (ViMe₂SiO_{1/2})_{0.25}(MeSiO_{3/2})_{0.25}(PhSiO_{3/2})_{0.50}, (ViMe₂SiO_{1/2})_{0.15}(PhSiO_{3/2})_{0.75}(SiO_{4/2})_{0.1}, and (Vi₂MeSiO_{1/2})_{0.15}(ViMe₂SiO_{1/2})_{0.1} (PhSiO_{3/2})_{0.75},
wherein Me is methyl, Vi is vinyl, Ph is phenyl, and the numerical subscripts outside the parenthesis denote mole fractions corresponding to either w, x, y, or z as described above for formula (I). The sequence of units in the preceding formulae is not to be viewed in any way as limiting to the scope of the invention.

When R² is predominantly hydrogen, specific examples of silicone resins represented by formula (I) above include, but are not limited to, resins having the following formulae: (HMe₂SiO_{1/2})_{0.25}(PhsiO_{3/2})_{0.75}, (HMeSiO_{2/2})_{0.3}(PhSiO_{3/2})_{0.6}(MeSiO_{3/2})_{0.1}, and (Me₃SiO_{1/2})_{0.1}(H₂SiO_{2/2})_{0.1}(MeSiO_{3/2})_{0.4}(PhSiO_{3/2})_{0.4},
wherein Me is methyl, Ph is phenyl, and the numerical subscripts outside the parenthesis denote mole fractions. The sequence of units in the preceding formulae is not to be viewed in any way as limiting to the scope of the invention.

The silicone resin represented by formula (I) typically has a number-average molecular weight (Mₙ) of from 500 to 50,000, alternatively from 500 to 10,000, alternatively 1,000 to 3,000, where the molecular weight is determined by gel permeation chromatography employing a low angle laser light scattering detector, or a refractive index detector and silicone resin (MQ) standards.

The viscosity of the silicone resin represented by formula (I) at 25°C is typically from 0.01 to 100,000 Pa·s, alternatively from 0.1 to 10,000 Pa·s, alternatively from 1 to 100 Pa·s.

The silicone resin represented by formula (I) typically includes less than 10% (w/w), alternatively less than 5% (w/w), alternatively less than 2% (w/w), of silicon-bonded hydroxy groups, as determined by ²⁹Si NMR.

Methods of preparing silicone resins represented by formula (I) are well known in the art; many of these resins are commercially available. Silicone resins represented by formula (I) are typically prepared by cohydrolyzing the appropriate mixture of chlorosilane precursors in an organic solvent, such as toluene. For example, a silicone resin including R¹R²₂SiO_{1/2} units and R²SiO_{3/2} units can be prepared by cohydrolyzing a first compound having the formula R¹R²₂SiCl and a second compound having the formula R²SiCl₃ in toluene, where R¹ and R² are as defined and exemplified above, to form aqueous hydrochloric acid and the silicone resin, which is a hydrolyzate of the first and second compounds. The aqueous hydrochloric acid and the silicone resin are separated, the silicone resin is washed with water to remove residual acid, and the silicone resin is heated in the presence of a mild condensation catalyst to "body" the silicone resin to a desired viscosity.

If desired, the silicone resin can be further treated with a condensation catalyst in an organic solvent to reduce the content of silicon-bonded hydroxy groups. Alternatively, first or second compounds containing hydrolysable groups other than chloro groups, such -Br, -I, -OCH₃, -OC(O)CH₃, -N(CH₃)₂, NHCOCH₃, and - SCH₃, can be cohydrolyzed to form the silicone resin. The properties of the silicone resin depend on the types of first and second compounds, the mole ratio of first and second compounds, the degree of condensation, and the processing conditions.

The hydrosilylation-curable silicone composition further includes a cross-linking agent (B) having silicon-bonded hydrogen atoms or silicon-bonded alkenyl groups capable of reacting with the silicon-bonded alkenyl groups or silicon-bonded hydrogen atoms in the silicone resin. The cross-linking agent (B) has an average of at least two silicon-bonded hydrogen atoms per molecule, alternatively at least three silicon-bonded hydrogen atoms per molecule. It is generally understood that cross-linking occurs when the sum of the average number of alkenyl groups per molecule in the silicone resin (A) and the average number of silicon-bonded hydrogen atoms per molecule in the cross-linking agent (B) is greater than four. The cross-linking agent (B) is present in an amount sufficient to cure the silicone resin (A).

The cross-linking agent (B) is typically an organosilicon compound and may be further defined as an organohydrogensilane, an organohydrogensiloxane, or a combination thereof. The structure of the organosilicon compound can be linear, branched, cyclic, or resinous. In acyclic polysilanes and polysiloxanes, the silicon-bonded hydrogen atoms can be located at terminal, pendant, or at both terminal and pendant positions. Cyclosilanes and cyclosiloxanes typically have from 3 to 12 silicon atoms, alternatively from 3 to 10 silicon atoms, alternatively from 3 to 4 silicon atoms.

The organohydrogensilane can be a monosilane, disilane, trisilane, or polysilane. When R² is predominantly the alkenyl group, specific examples of organohydrogensilanes that are suitable for purposes of the present invention include, but are not limited to, diphenylsilane, 2-chloroethylsilane, bis[(p-dimethylsilyl)phenyl]ether, 1,4-dimethyldisilylethane, 1,3,5-tris(dimethylsilyl)benzene, 1,3,5-trimethyl-1,3,5-trisilane, poly(methylsilylene)phenylene, and poly(methylsilylene)methylene. When R² is predominantly hydrogen, specific examples of organohydrogensilanes that are suitable for purposes of the present invention include, but are not limited to, silanes having the following formulae: Vi₄Si, PhSiVi₃, MeSiVi₃, PhMeSiVi₂, Ph₂SiVi₂, and PhSi(CH₂CH=CH₂)₃,
wherein Me is methyl, Ph is phenyl, and Vi is vinyl.

The organohydrogensilane can also have the formula:

HR¹₂Si-R³-SiR¹₂H (III)

wherein R¹ is as defined and exemplified above and R³ is a hydrocarbylene group free of aliphatic unsaturation having a formula selected from the following structures: 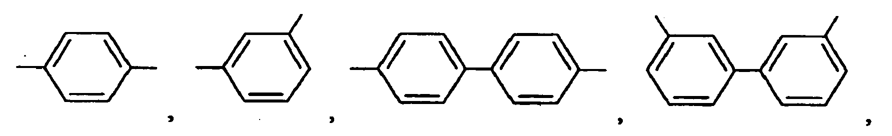 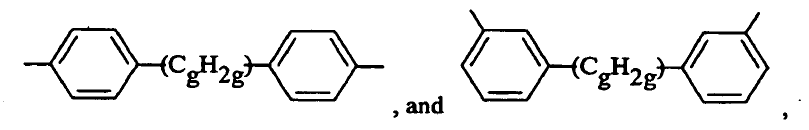 wherein g is from 1 to 6.

Specific examples of organohydrogensilanes having the formula (III), wherein R¹ and R³ are as described and exemplified above include, but are not limited to, organohydrogensilanes having a formula selected from the following structures: 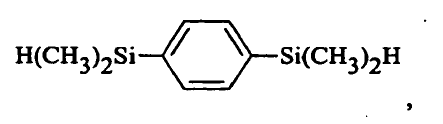 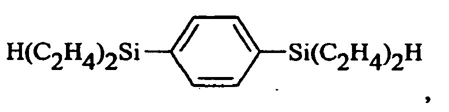 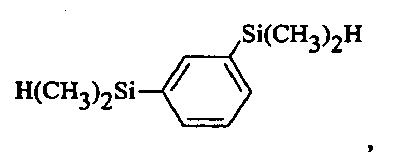 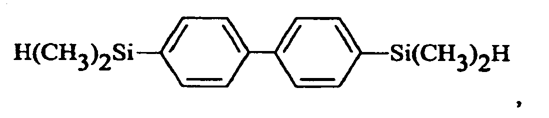 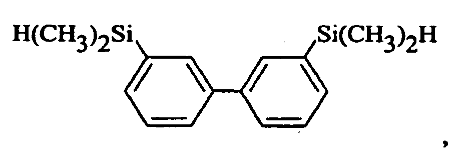 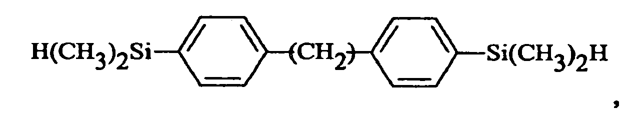 and

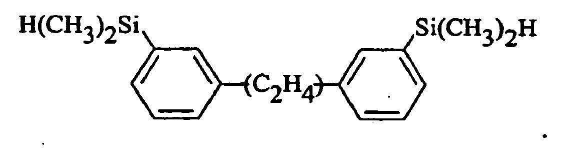

Methods of preparing the organohydrogensilanes are known in the art. For example, organohydrogensilanes can be prepared by reaction of Grignard reagents with alkyl or aryl halides. In particular, organohydrogensilanes having the formula HR¹₂Si-R³-SiR¹₂H can be prepared by treating an aryl dihalide having the formula R³X₂ with magnesium in ether to produce the corresponding Grignard reagent and then treating the Grignard reagent with a chlorosilane having the formula HR¹₂SiCl, where R¹ and R³ are as described and exemplified above.

The organohydrogensiloxane can be a disiloxane, trisiloxane, or polysiloxane. Examples of organosiloxanes suitable for use as the cross-linking agent (B) when R² is predominantly hydrogen include, but are not limited to, siloxanes having the following formulae:

PhSi(OSiMe₂H)₃, Si(OSiMe₂H)₄, MeSi(OSiMe₂H)₃, and Ph₂Si(OSiMe₂H)₂,

wherein Me is methyl, and Ph is phenyl.

Specific examples of organohydrogensiloxanes that are suitable for purposes of the present invention when R² is predominantly alkenyl group include, but are not limited to, 1,1,3,3-tetramethyldisiloxane, 1,1,3,3-tetraphenyldisiloxane, phenyltris(dimethylsiloxy)silane, 1,3,5-trimethylcyclotrisiloxane, a trimethylsiloxy-terminated poly(methylhydrogensiloxane), a trimethylsiloxy-terminated poly(dimethylsiloxane/methylhydrogensiloxane), a dimethylhydrogensiloxy-terminated poly(methylhydrogensiloxane), and a resin including HMe₂SiO_{1/2} units, Me₃SiO_{1/2} units, and SiO_{4/2} units, wherein Me is methyl.

The organohydrogensiloxane can also be an organohydrogenpolysiloxane resin. The organohydrogenpolysiloxane resin is typically a copolymer including R⁴SiO_{3/2} units, i.e., T units, and/or SiO_{4/2} units, i.e., Q units, in combination with R¹R⁴₂SiO_{1/2} units, i.e., M units, and/or R⁴₂SiO_{2/2} units, i.e., D units, wherein R¹ is as described and exemplified above. For example, the organohydrogenpolysiloxane resin can be a DT resin, an MT resin, an MDT resin, a DTQ resin, an MTQ resin, an MDTQ resin, a DQ resin, an MQ resin, a DTQ resin, an MTQ resin, or an MDQ resin.

The group represented by R⁴ is either R¹ or an organosilylalkyl group having at least one silicon-bonded hydrogen atom. Examples of organosilylalkyl groups represented by R⁴ include, but are not limited to, groups having a formula selected from the following structures: 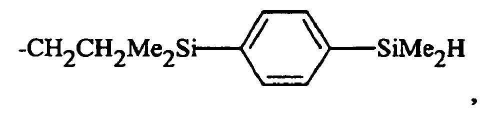 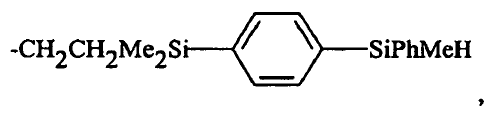 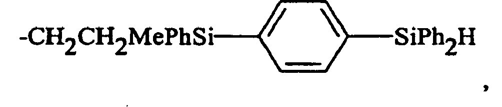 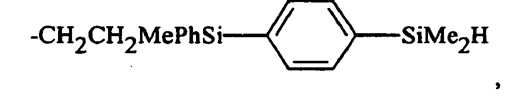 -CH₂CH₂SiMe₂H, -CH₂CH₂SiMe₂CₙH₂ₙSiMe₂H, -CH₂CH₂SiMe₂CₙH₂ₙSiMePhH, -CH₂CH₂SiMePhH, -CH₂CH₂SiPh₂H, -CH₂CH₂SiMePhCₙH₂ₙSiPh₂H, -CH₂CH₂SiMePhCₙH₂ₙSiMe₂H, -CH₂CH₂SiMePhOSiMePhH, and -CH₂CH₂SiMePhOSiPh(OSiMePhH)₂,
wherein Me is methyl, Ph is phenyl, and the subscript n has a value of from 2 to 10. Typically, at least 50 mol%, alternatively at least 65 mol%, alternatively at least 80 mol% of the groups represented by R⁴ in the organohydrogenpolysiloxane resin are organosilylalkyl groups having at least one silicon-bonded hydrogen atom. As used herein, the mol% of organosilylalkyl groups in R⁴ is defined as a ratio of the number of moles of silicon-bonded organosilylalkyl groups in the silicone resin to the total number of moles of the R⁴ groups in the resin, multiplied by 100.

The organohydrogenpolysiloxane resin typically has the formula:

(R¹R⁴₂SiO_{1/2})_{w}(R⁴₂SiO_{2/2})ₓ(R⁴SiO_{3/2})_{y}(SiO_{4/2})_{z} (IV)

wherein R¹, R⁴, w, x, y, and z are each as defined and exemplified above.

Specific examples of organohydrogenpolysiloxane resins represent by formula (IV) above include, but are not limited to, resins having the following formulae:
((HMe₂SiC₆H₄SiMe₂CH₂CH₂)₂MeSiO_{1/2})_{0.12}(PhSiO_{3/2})0.88, ((HMe₂SiC₆H₄SiMe₂CH₂CH₂)₂MeSiO_{1/2})_{0.17}(PhSiO_{3/2})_{0.83}, ((HMe₂SiC₆H₄SiMe₂CH₂CH₂)₂MeSiO_{1/2})0.17(MeSiO_{3/2})_{0.17}(PhsiO_{3/2})_{0.66}, ((HMe₂SiC₆H₄SiMe₂CH₂CH₂)₂MeSiO_{1/2})_{0.15}(PhSiO_{3/2})_{0.75}(SiO_{4/2})_{0.10}, and ((HMe₂SiC₆H₄SiMe₂CH₂CH₂)₂MeSiO_{1/2})_{0.08}((HMe₂SiC₆H₄SiMe₂CH₂CH₂) Me₂SiO_{1/2})_{0.06}(PhSiO_{3/2})_{0.86},
wherein Me is methyl, Ph is phenyl, C₆H₄ denotes a para-phenylene group, and the numerical subscripts outside the parenthesis denote mole fractions. The sequence of units in the preceding formulae is not to be viewed in any way as limiting to the scope of the invention.

Specific examples of organohydrogenpolysiloxane resins include, but are not limited to, resins having the following formulae:
((HMe₂SiC₆H₄SiMe₂CH₂CH₂)₂MeSiO_{1/2})_{0.12}(PhSiO_{3/2})_{0.88}, ((HMe₂SiC₆H₄SiMe₂CH₂CH₂)₂MeSiO_{1/2})_{0.17}(PhSiO_{3/2})_{0.83}, ((HMe₂SiC₆H₄SiMe₂CH₂CH₂)₂MeSiO_{1/2})_{0.17}(MeSiO_{3/2})_{0.17}(PhSiO_{3/2})_{0.66}, ((HMe₂SiC₆H₄SiMe₂CH₂CH₂)₂MeSiO_{1/2})_{0.15}(PhSiO_{3/2})_{0.75}(SiO_{4/2})_{0.10}, and ((HMe₂SiC₆H₄SiMe₂CH₂CH₂)₂MeSiO_{1/2})_{0.08}((HMe₂SiC₆H₄SiMe₂CH₂CH₂) Me₂SiO_{1/2})_{0.06}(PhSiO_{3/2})_{0.86}, where Me is methyl, Ph is phenyl, C₆H₄ denotes a para-phenylene group, and the numerical subscripts outside the parenthesis denote mole fractions. The sequence of units in the preceding formulae is not to be viewed in any way as limiting to the scope of the invention.

The organohydrogenpolysiloxane resin having the formula (IV) can be prepared by reacting a reaction mixture including (a) a silicone resin having the formula (R¹R²₂SiO_{1/2})_{w}(R²₂SiO_{2/2})ₓ(R²SiO_{3/2})_{y}(SiO_{4/2})_{z} represented by formula (I) above and an organosilicon compound (b) having an average of from two to four silicon-bonded hydrogen atoms per molecule and a molecular weight of less than 1,000, in the presence of (c) a hydrosilylation catalyst and, optionally, (d) an organic solvent, wherein R¹, R², w, x, y, and z are each as defined and exemplified above, provided the silicone resin (a) has an average of at least two silicon-bonded alkenyl groups per molecule, and the mole ratio of silicon-bonded hydrogen atoms in (b) to alkenyl groups in (a) is from 1.5 to 5. Silicone resin (a) can be the same as or different than the specific silicone resin used as component (A) in the hydrosilylation-curable silicone composition.

As set forth above, organosilicon compound (b) has an average of from two to four silicon-bonded hydrogen atoms per molecule. Alternatively, the organosilicon compound (b) has an average of from two to three silicon-bonded hydrogen atoms per molecule. As also set forth above, the organosilicon compound (b) typically has a molecular weight less than 1,000, alternatively less than 750, alternatively less than 500. The organosilicon compound (b) further includes silicon-bonded organic groups that may be selected from the group of hydrocarbyl groups and halogen-substituted hydrocarbyl groups, both free of aliphatic unsaturation, which are as described and exemplified above for R¹.

Organosilicon compound (b) can be an organohydrogensilane or an organohydrogensiloxane, each of which are defined and exemplified in detail above.

Organosilicon compound (b) can be a single organosilicon compound or a mixture comprising two or more different organosilicon compounds, each as described above. For example, organosilicon compound (B) can be a single organohydrogensilane, a mixture of two different organohydrogensilanes, a single organohydrogensiloxane, a mixture of two different organohydrogensiloxanes, or a mixture of an organohydrogensilane and an organohydrogensiloxane. The mole ratio of silicon-bonded hydrogen atoms in organosilicon compound (b) to alkenyl groups in silicone resin (a) is typically from 1.5 to 5, alternatively from 1.75 to 3, alternatively from 2 to 2.5.

Hydrosilylation catalyst (c) can be any of the well-known hydrosilylation catalysts comprising a platinum group metal (i.e., platinum, rhodium, ruthenium, palladium, osmium and iridium) or a compound containing a platinum group metal. Typically, the platinum group metal is platinum, based on its high activity in hydrosilylation reactions.

Specific hydrosilylation catalysts suitable for (c) include the complexes of chloroplatinic acid and certain vinyl-containing organosiloxanes disclosed by Willing in U.S. Pat. No. 3,419,593, the portions of which address hydrosilylation catalysts are hereby incorporated by reference. A catalyst of this type is the reaction product of chloroplatinic acid and 1,3-diethenyl-1,1,3,3-tetramethyldisiloxane.

**,** The hydrosilylation catalyst can also be a supported hydrosilylation catalyst comprising a solid support having a platinum group metal on the surface thereof. A supported catalyst can be conveniently separated from the organohydrogenpolysiloxane resin represented by formula (IV), for example, by filtering the reaction mixture. Examples of supported catalysts include, but are not limited to, platinum on carbon, palladium on carbon, ruthenium on carbon, rhodium on carbon, platinum on silica, palladium on silica, platinum on alumina, palladium on alumina, and ruthenium on alumina.

The concentration of hydrosilylation catalyst (c) is sufficient to catalyze the addition reaction of silicone resin (a) with organosilicon compound (b). Typically, the concentration of hydrosilylation catalyst (c) is sufficient to provide from 0.1 to 1000 ppm of a platinum group metal, alternatively from 1 to 500 ppm of a platinum group metal, alternatively from 5 to 150 ppm of a platinum group metal, based on the combined weight of silicone resin (a) and organosilicon compound (b). The rate of reaction is very slow below 0.1 ppm of platinum group metal. The use of more than 1000 ppm of platinum group metal results in no appreciable increase in reaction rate, and is therefore uneconomical.

Organic solvent (d) includes at least one organic solvent. The organic solvent (d) can be any aprotic or dipolar aprotic organic solvent that does not react with silicone resin (a), organosilicon compound (b), or the resulting organohydrogenpolysiloxane resin under the conditions of the present method, and is miscible with components (a), (b), and the organohydrogenpolysiloxane resin.

Examples of organic solvents (d) that are suitable for purposes of the present invention include, but are not limited to, saturated aliphatic hydrocarbons such as n-pentane, hexane, n-heptane, isooctane and dodecane; cycloaliphatic hydrocarbons such as cyclopentane and cyclohexane; aromatic hydrocarbons such as benzene, toluene, xylene and mesitylene; cyclic ethers such as tetrahydrofuran (THF) and dioxane; ketones such as methyl isobutyl ketone (MIBK); halogenated alkanes such as trichloroethane; and halogenated aromatic hydrocarbons such as bromobenzene and chlorobenzene. Organic solvent (d) can be a single organic solvent or a mixture comprising two or more different organic solvents, each as described above. The concentration of organic solvent (d) is typically from 0 to 99% (w/w), alternatively from 30 to 80% (w/w), alternatively from 45 to 60% (w/w), based on the total weight of the reaction mixture.

The reaction to form the organohydrogenpolysiloxane resin represented by formula (IV) can be carried out in any standard reactor suitable for hydrosilylation reactions. Suitable reactors include glass and Teflon-lined glass reactors. Typically, the reactor is equipped with a means of agitation, such as stirring. Also, typically, the reaction is carried out in an inert atmosphere, such as nitrogen or argon, in the absence of moisture.

The silicone resin (a), organosilicon compound (b), hydrosilylation catalyst (c), and, optionally, organic solvent (d), can be combined in any order. Typically, organosilicon compound (b) and hydrosilylation catalyst (c) are combined before the introduction of the silicone resin (a) and, optionally, organic solvent (d). The reaction is typically carried out at a temperature of from 0 to 150°C, alternatively from room temperature (~23 ± 2°C) to 115°C. When the temperature is less than 0 °C, the rate of reaction is typically very slow. The reaction time depends on several factors, such as the structures of the silicone resin (a) and the organosilicon compound (b), and the temperature. The time of reaction is typically from 1 to 24 h at a temperature of from room temperature (~23 ± 2°C) to 150 °C. The optimum reaction time can be determined by routine experimentation.

The organohydrogenpolysiloxane resin represented by formula (IV) can be used without isolation or purification or the organohydrogenpolysiloxane resin can be separated from most of the organic solvent (d) by conventional methods of evaporation. For example, the reaction mixture can be heated under reduced pressure. Moreover, when the hydrosilylation catalyst (c) is a supported catalyst, as described above, the organohydrogenpolysiloxane resin can be readily separated from the hydrosilylation catalyst (c) by filtering the reaction mixture. However, the hydrosilylation catalyst may remain mixed with the organohydrogenpolysiloxane resin and be used as hydrosilylation catalyst (C).

The cross-linking agent (B) can be a single organosilicon compound or a mixture comprising two or more different organosilicon compounds, each as described above. For example, the cross-linking agent (B) can be a single organohydrogensilane, a mixture of two different organohydrogensilanes, a single organohydrogensiloxane, a mixture of two different organohydrogensiloxanes, or a mixture of an organohydrogensilane and an organohydrogensiloxane. In particular, the cross-linking agent (B) can be a mixture comprising the organohydrogenpolysiloxane resin having the formula (IV) in an amount of at least 0.5% (w/w), alternatively at least 50% (w/w), alternatively at least 75% (w/w), based on the total weight of the cross-linking agent (B), with the cross-linking agent (B) further comprising an organohydrogensilane and/or organohydrogensiloxane, the latter different from the organohydrogenpolysiloxane resin.

The concentration of cross-linking agent (B) is sufficient to cure (cross-link) the silicone resin (A). The exact amount of cross-linking agent (B) depends on the desired extent of cure. The concentration of cross-linking agent (B) is typically sufficient to provide from 0.4 to 2 moles of silicon-bonded hydrogen atoms, alternatively from 0.8 to 1.5 moles of silicon-bonded hydrogen atoms, alternatively from 0.9 to 1.1 moles of silicon-bonded hydrogen atoms, per mole of alkenyl groups in silicone resin (A).

Hydrosilylation catalyst (C) includes at least one hydrosilylation catalyst that promotes the reaction between silicone resin (A) and cross-linking agent (B). In one embodiment, the hydrosilylation catalyst (C) may be the same as the hydrosilylation catalyst (c) described above for producing the organohydrogenpolysiloxane resin. In addition, the hydrosilylation catalyst (C) can also be a microencapsulated platinum group metal-containing catalyst comprising a platinum group metal encapsulated in a thermoplastic resin. Hydrosilylation-curable silicone compositions including microencapsulated hydrosilylation catalysts are stable for extended periods of time, typically several months or longer, under ambient conditions, yet cure relatively rapidly at temperatures above the melting or softening point of the thermoplastic resin(s). Microencapsulated hydrosilylation catalysts and methods of preparing them are well known in the art, as exemplified in U.S. Pat. No. 4,766,176 and the references cited therein, and U.S. Pat. No. 5,017,654. The hydrosilylation catalyst (C) can be a single catalyst or a mixture comprising two or more different catalysts that differ in at least one property, such as structure, form, platinum group metal, complexing ligand, and thermoplastic resin.

In another embodiment, the hydrosilylation catalyst (C) may be at least one photoactivated hydrosilylation catalyst. The photoactivated hydrosilylation catalyst can be any hydrosilylation catalyst capable of catalyzing the hydrosilylation of the silicone resin (A) and the cross-linking agent (B) upon exposure to radiation having a wavelength of from 150 to 800 nm. The photoactivated hydrosilylation catalyst can be any of the well-known hydrosilylation catalysts comprising a platinum group metal or a compound containing a platinum group metal. The platinum group metals include platinum, rhodium, ruthenium, palladium, osmium, and iridium. Typically, the platinum group metal is platinum, based on its high activity in hydrosilylation reactions. The suitability of particular photoactivated hydrosilylation catalysts for use in the silicone composition of the present invention can be readily determined by routine experimentation.

Specific examples of photoactivated hydrosilylation catalysts suitable for purposes of the present invention include, but are not limited to, platinum(II) β-diketonate complexes such as platinum(II) bis(2,4-pentanedioate), platinum(II) bis(2,4-hexanedioate), platinum(II) bis(2,4-heptanedioate), platinum(II) bis(1-phenyl-1,3-butanedioate, platinum(II) bis(1,3-diphenyl-1,3-propanedioate), platinum(II) bis(1,1,1,5,5,5-hexafluoro-2,4-pentanedioate); (η-cyclopentadienyl)trialkylplatinum complexes, such as (Cp)trimethylplatinum, (Cp)ethyldimethylplatinum, (Cp)triethylplatinum, (chloro-Cp)trimethylplatinum, and (trimethylsilyl-Cp)trimethylplatinum, where Cp represents cyclopentadienyl; triazene oxide-transition metal complexes, such as Pt[C₆H₅NNNOCH₃]₄, Pt[p-CN-C₆H₄NNNOC₆H₁₁]₄, Pt[p-H₃COC₆H₄NNNOC₆H₁₁]₄, Pt[p-CH₃(CH₂)ₓ-C₆H₄NNNOCH₃]₄, 1,5-cyclooctadiene.Pt[p-CN-C₆H₄NNNOC₆H₁₁]₂, 1,5-cyclooctadiene.Pt[p-CH₃O-C₆H₄NNNOCH₃]₂, [(C₆H₅)3P]₃Rh[p-CN-C₆H₄NNNOC₆H₁₁], and Pd[p-CH₃(CH₂)ₓ-C₆H₄NNNOCH₃]₂, where x is 1, 3, 5, 11, or 17; (η-diolefin)(σ-aryl)platinum complexes, such as (η⁴-1,5-cyclooctadienyl)diphenylplatinum, η⁴-1,3,5,7-cyclooctatetraenyl)diphenylplatinum, (η⁴-2,5-norboradienyl)diphenylplatinum, (η⁴-1,5-cyclooctadienyl)bis-(4-dimethylaminophenyl)platinum, (η⁴-1,5-cyclooctadienyl)bis-(4-acetylphenyl)platinum, and (η⁴-1,5-cyclooctadienyl)bis-(4-trifluormethylphenyl)platinum. Typically, the photoactivated hydrosilylation catalyst is a Pt(II) β-diketonate complex and more typically the catalyst is platinum(II) bis(2,4-pentanedioate). The hydrosilylation catalyst (C) can be a single photoactivated hydrosilylation catalyst or a mixture comprising two or more different photoactivated hydrosilylation catalysts.

Methods of preparing photoactivated hydrosilylation catalysts are well known in the art. For example, methods of preparing platinum(II) β-diketonates are reported by Guo et al. (Chemistry of Materials, 1998, 10, 531-536). Methods of preparing (η-cyclopentadienyl)-trialkylplatinum complexes are disclosed in U.S. Patent No. 4,510,094. Methods of preparing triazene oxide-transition metal complexes are disclosed in U.S. Patent No. 5,496,961. Methods of preparing (η-diolefin)(σ-aryl)platinum complexes are taught in U.S. Patent No. 4,530,879.

The concentration of the hydrosilylation catalyst (C) is sufficient to catalyze the addition reaction of the silicone resin (A) and the cross-linking agent (B). The concentration of the hydrosilylation catalyst (C) is sufficient to provide typically from 0.1 to 1000 ppm of platinum group metal, alternatively from 0.5 to 100 ppm of platinum group metal, alternatively from 1 to 25 ppm of platinum group metal, based on the combined weight of the silicone resin (A) and the cross-linking agent (B).

Optionally, the hydrosilylation-curable silicone composition further includes (D) a silicone rubber having a formula selected from the group of (i) R¹R²₂SiO(R²₂SiO)ₐSiR²₂R¹ and (ii) R⁵R¹₂SiO(R¹R⁵SiO)_{b}SiR¹₂R⁵; wherein R¹ and R² are as defined and exemplified above, R⁵ is R¹ or -H, subscripts a and b each have a value of from 1 to 4, alternatively from 2 to 4, alternatively from 2 to 3, and w, x, y, and z are also as defined and exemplified above, provided the silicone resin and the silicone rubber (D)(i) each have an average of at least two silicon-bonded alkenyl groups per molecule, the silicone rubber (D)(ii) has an average of at least two silicon-bonded hydrogen atoms per molecule, and the mole ratio of silicon-bonded alkenyl groups or silicon-bonded hydrogen atoms in the silicone rubber (D) to silicon-bonded alkenyl groups in the silicone resin (A) is from 0.01 to 0.5.

Specific examples of silicone rubbers suitable for use as component (D)(i) include, but are not limited to, silicone rubbers having the following formulae:
ViMe₂SiO(Me₂SiO)ₐSiMe₂Vi, ViMe₂SiO(Ph₂SiO)ₐSiMe₂Vi, and ViMe₂SiO(PhMeSiO)ₐ SiMe₂Vi,
wherein Me is methyl, Ph is phenyl, Vi is vinyl, and the subscript a has a value of from 1 to 4. Silicone rubber (D)(i) can be a single silicone rubber or a mixture comprising two or more different silicone rubbers that each satisfy the formula for (D)(i).

Specific examples of silicone rubbers suitable for use as silicone rubber (D)(ii) include, but are not limited to, silicone rubbers having the following formulae:

HMe₂SiO(Me₂SiO)_{b}SiMe₂H, HMe₂SiO(Ph₂SiO)_{b}SiMe₂H, HMe₂SiO(PhMeSiO)_{b} SiMe₂H, and HMe₂SiO(Ph₂SiO)₂(Me₂SiO)₂SiMe₂H,

wherein Me is methyl, Ph is phenyl, and the subscript b has a value of from 1 to 4. Component (D)(ii) can be a single silicone rubber or a mixture comprising two or more different silicone rubbers that each satisfy the formula for (D)(ii).

The mole ratio of silicon-bonded alkenyl groups or silicon-bonded hydrogen atoms in the silicone rubber (D) to silicon-bonded alkenyl groups in the silicone resin (A) is typically from 0.01 to 0.5, alternatively from 0.05 to 0.4, alternatively from 0.1 to 0.3.

When the silicone rubber (D) is (D)(i), the concentration of the cross-linking agent (B) is such that the ratio of the number of moles of silicon-bonded hydrogen atoms in the cross-linking agent (B) to the sum of the number of moles of silicon-bonded alkenyl groups in the silicone resin (A) and the silicone rubber (D)(i) is typically from 0.4 to 2, alternatively from 0.8 to 1.5, alternatively from 0.9 to 1.1. Furthermore, when the silicone rubber (D) is (D)(ii), the concentration of the cross-linking agent (B) is such that the ratio of the sum of the number of moles of silicon-bonded hydrogen atoms in the cross-linking agent (B) and the silicone rubber (D)(ii) to the number of moles of silicon-bonded alkenyl groups in the silicone resin (A) is typically from 0.4 to 2, alternatively from 0.8 to 1.5, alternatively from 0.9 to 1.1.

Methods of preparing silicone rubbers containing silicon-bonded alkenyl groups or silicon-bonded hydrogen atoms are well known in the art; many of these compounds are commercially available.

In another embodiment of the present invention, the hydrosilylation-curable silicone composition comprises (A¹) a rubber-modified silicone resin prepared by reacting the silicone resin (A) and at least one silicone rubber (D)(iii) selected from rubbers having the following formulae:
R⁵R¹₂SiO(R¹R⁵SiO)_{c}SiR¹₂R⁵, and
R¹R²₂SiO(R²₂SiO)_{d}SiR²₂R¹,
wherein R¹ and R⁵ are as defined and exemplified above and c and d each have a value of from 4 to 1000, alternatively from 10 to 500, alternatively from 10 to 50, in the presence of the hydrosilylation catalyst (c) and, optionally, an organic solvent, provided the silicone resin (A) has an average of at least two silicon-bonded alkenyl groups per molecule, the silicone rubber (D)(iii) has an average of at least two silicon-bonded hydrogen atoms per molecule, and the mole ratio of silicon-bonded hydrogen atoms in the silicone rubber (D)(iii) to silicon-bonded alkenyl groups in silicone resin (A) is from 0.01 to 0.5. By "at least one silicone rubber", it is meant that only one of the rubbers represented by the formulae are necessary for (D)(iii), and that combinations of the rubbers represented by the formulae may be used. When organic solvent is present, the rubber-modified silicone resin (A¹) is miscible in the organic solvent and does not form a precipitate or suspension.

The silicone resin (A), silicone rubber (D)(iii), hydrosilylation catalyst (c), and organic solvent can be combined in any order. Typically, the silicone resin (A), silicone rubber (D)(iii), and organic solvent are combined before the introduction of the hydrosilylation catalyst (c).

The reaction is typically carried out at a temperature of from room temperature (~23 ± 2°C) to 150 °C, alternatively from room temperature to 100 °C. The reaction time depends on several factors, including the structures of the silicone resin (A) and the silicone rubber (D)(iii) and the temperature. The components are typically allowed to react for a period of time sufficient to complete the hydrosilylation reaction. This means the components are typically allowed to react until at least 95 mol%, alternatively at least 98 mol%, alternatively at least 99 mol%, of the silicon-bonded hydrogen atoms originally present in the silicone rubber (D)(iii) have been consumed in the hydrosilylation reaction, as determined by FTIR spectrometry. The time of reaction is typically from 0.5 to 24 h at a temperature of from room temperature (~23 ± 2°C) to 100 °C. The optimum reaction time can be determined by routine experimentation.

The mole ratio of silicon-bonded hydrogen atoms in the silicone rubber (D)(iii) to silicon-bonded alkenyl groups in the silicone resin (A) is typically from 0.01 to 0.5, alternatively from 0.05 to 0.4, alternatively from 0.1 to 0.3.

The concentration of the hydrosilylation catalyst (c) is sufficient to catalyze the addition reaction of the silicone resin (A) with the silicone rubber (D)(iii). Typically, the concentration of the hydrosilylation catalyst (c) is sufficient to provide from 0.1 to 1000 ppm of a platinum group metal, based on the combined weight of the resin and the rubber.

The concentration of the organic solvent is typically from 0 to 95% (w/w), alternatively from 10 to 75% (w/w), alternatively from 40 to 60% (w/w), based on the total weight of the reaction mixture.

The rubber-modified silicone resin (A¹) can be used without isolation or purification, or the rubber-modified silicone resin (A¹) can be separated from most of the solvent by conventional methods of evaporation. For example, the reaction mixture can be heated under reduced pressure. Moreover, when the hydrosilylation catalyst (c) is a supported catalyst, described above, the rubber-modified silicone resin (A¹) can be readily separated from the hydrosilylation catalyst (c) by filtering the reaction mixture. However, when the rubber-modified silicone resin (A¹) is not separated from the hydrosilylation catalyst (c) used to prepare the rubber-modified silicone resin (A¹), the hydrosilylation catalyst (c) may be used as the hydrosilylation catalyst (C).

The hydrosilylation-curable silicone composition of the present invention can comprise additional ingredients, as known in the art. Examples of additional ingredients include, but are not limited to, hydrosilylation catalyst inhibitors, such as 3-methyl-3-penten-1-yne, 3,5-dimethyl-3-hexen-1-yne, 3,5-dimethyl-1-hexyn-3-ol, 1-ethynyl-1-cyclohexanol, 2-phenyl-3-butyn-2-ol, vinylcyclosiloxanes, and triphenylphosphine; adhesion promoters, such as the adhesion promoters taught in U.S. Patent Nos. 4,087,585 and 5,194,649; dyes; pigments; anti-oxidants; heat stabilizers; UV stabilizers; flame retardants; flow control additives; and diluents, such as organic solvents and reactive diluents.

As an alternative to the hydrosilylation-curable silicone composition, condensation-curable silicone compositions are also suitable for the silicone composition of the present invention.

The condensation-curable silicone composition typically includes a silicone resin (A²) having silicon-bonded hydrogen atoms, silicon-bonded hydroxy groups, or silicon-bonded hydrolysable groups, optionally, a cross-linking agent (B¹) having silicon-bonded hydrolysable groups and, optionally, a condensation catalyst (C¹). The condensation curable silicone resin (A²) is typically a copolymer comprising R¹SiO_{3/2} units, i.e., T units, and/or SiO_{4/2} units, i.e., Q units, in combination with R¹R⁶₂SiO_{1/2} units, i.e., M units, and/or R⁶₂SiO_{2/2} units, i.e., D units, wherein R¹ is set forth above, R⁶ is R¹, -H, -OH, or a hydrolysable group. For example, the silicone resin can be a DT resin, an MT resin, an MDT resin, a DTQ resin, an MTQ resin, an MDTQ resin, a DQ resin, an MQ resin, a DTQ resin, an MTQ resin, or an MDQ resin.

According to one embodiment, the silicone resin (A²) has the formula:

(R¹R⁶₂SiO_{1/2})_{w'}(R⁶₂SiO_{2/2})_{x'}(R⁶SiO_{3/2})_{y'}(SiO_{4/2})_{z'} (V)

wherein R¹ and R⁶ are defined and exemplified above, w' is from 0 to 0.8, alternatively from 0.02 to 0.75, alternatively from 0.05 to 0.3, x' is from 0 to 0.95, alternatively from 0.05 to 0.8, alternatively from 0.1 to 0.3, y' is from 0 to 1, alternatively from 0.25 to 0.8, alternatively from 0.5 to 0.8, and z' is from 0 to 0.99, alternatively from 0.2 to 0.8, alternatively from 0.4 to 0.6. The silicone resin (A²) has an average of at least two silicon-bonded hydrogen atoms, hydroxy groups, or hydrolysable groups per molecule. As used herein the term "hydrolysable group" means the silicon-bonded group reacts with water in the absence of a catalyst at any temperature from room temperature (∼23 ± 2 °C) to 100 °C within several minutes, for example thirty minutes, to form a silanol (Si-OH) group. Examples of hydrolysable groups represented by R⁶ include, but are not limited to, -Cl, -Br, -OR⁷, -OCH₂CH₂OR⁷, CH₃C(=O)O-, Et(Me)C=N-O-, CH₃C(=O)N(CH₃)-, and -ONH₂, wherein R⁷ is C₁ to C₈ hydrocarbyl or C₁ to C₈ halogen-substituted hydrocarbyl.

The hydrocarbyl and halogen-substituted hydrocarbyl groups represented by R⁷ typically have from 1 to 8 carbon atoms, alternatively from 3 to 6 carbon atoms. Acyclic hydrocarbyl and halogen-substituted hydrocarbyl groups containing at least 3 carbon atoms can have a branched or unbranched structure. Examples of hydrocarbyl groups represented by R⁷ include, but are not limited to, unbranched and branched alkyl, such as methyl, ethyl, propyl, 1-methylethyl, butyl, 1-methylpropyl, 2-methylpropyl, 1,1-dimethylethyl, pentyl, 1-methylbutyl, 1-ethylpropyl, 2-methylbutyl, 3-methylbutyl, 1,2-dimethylpropyl, 2,2-dimethylpropyl, hexyl, heptyl, and octyl; cycloalkyl, such as cyclopentyl, cyclohexyl, and methylcyclohexyl; phenyl; alkaryl, such as tolyl and xylyl; aralkyl, such as benzyl and phenethyl; alkenyl, such as vinyl, allyl, and propenyl; arylalkenyl, such as styryl; and alkynyl, such as ethynyl and propynyl. Examples of halogen-substituted hydrocarbyl groups represented by R⁷ include, but are not limited to, 3,3,3-trifluoropropyl, 3-chloropropyl, chlorophenyl, and dichlorophenyl.

Typically, at least 1 mol%, alternatively at least 5 mol%, alternatively at least 10 mol% of the groups R⁶ in the silicone resin (A²) are hydrogen, hydroxy, or a hydrolysable group. As used herein, the mol% of groups in R⁶ is defined as a ratio of the number of moles of silicon-bonded groups in the silicone resin (A²) to the total number of moles of the R⁶ groups in the silicone resin (A²), multiplied by 100.

Specific examples of cured silicone resins formed from silicone resin (A²) include, but are not limited to, cured silicone resins having the following formulae:

(MeSiO_{3/2})_{0.9}(Me(HO)SiO_{2/2})_{0.1}, (PhSiO_{3/2})_{0.7}(Ph(MeO)SiO_{2/2})_{0.3},

(Me₃SiO_{1/2})_{0.8}(SiO_{4/2})_{0.15}(HOSiO_{3/2})_{0.05},

(MeSiO_{3/2})_{0.67}(PhSiO_{3/2})_{0.23}(Ph(HO)SiO_{2/2})_{0.1},

(MeSiO_{3/2})_{0.45}(PhSiO_{3/2})_{0.24}(Ph(HO)SiO_{2/2})_{0.16}(Ph₂SiO_{2/2})_{0.1} (PhMeSiO_{2/2})₀. ₀₅,

(PhSiO_{3/2})_{0.3}(Ph(HO)SiO_{2/2})_{0.1}(MeSiO_{3/2})_{0.4}(Me(HO)SiO_{2/2})_{0.05}(PhSiO_{3/2})_{0.1}

(PhMeSiO_{2/2})_{0.05},

and

(PhSiO_{3/2})_{0.3}(Ph(MeO)SiO_{2/2})_{0.1} (MeSiO_{3/2})_{0.1}(PhMeSiO_{2/2})_{0.5},

wherein Me is methyl, Ph is phenyl, the numerical subscripts outside the parenthesis denote mole fractions, and the subscript n has a value such that the silicone resin typically has a number-average molecular weight of from 500 to 50,000. The sequence of units in the preceding formulae is not to be viewed in any way as limiting to the scope of the invention.

As set forth above, the silicone resin (A²) represented by formula (V) typically has a number-average molecular weight (Mₙ) of from 500 to 50,000. Alternatively, the silicone resin (A²) may have a Mₙ of at least 300, alternatively 1,000 to 3,000, where the molecular weight is determined by gel permeation chromatography employing a low angle laser light scattering detector, or a refractive index detector and silicone resin (MQ) standards.

The viscosity of the silicone resin (A²) at 25°C is typically from 0.01 Pa·s to solid, alternatively from 0.1 to 100,000 Pa·s, alternatively from 1 to 1,000 Pa·s.

In a second embodiment, the silicone resin (A²) can have the same formula (V) as set forth above, but with different values for the subscripts x and z and with the proviso that the sum of R⁶SiO_{3/2} units and SiO_{4/2} units is greater than zero and with the further proviso that the silicone resin (A²) of the second embodiment contains at least two silicon-bonded hydrogen atoms, at least two silicon-bonded hydroxy groups, or at least two silicon-bonded hydrolysable groups per molecule. More specifically, for the silicone resin (A²) of the second embodiment, w', y', R¹, and R⁶ remain the same as set forth above, x' typically has a value of from 0 to 0.6, alternatively from 0 to 0.45, alternatively from 0 to 0.25, z' typically has a value of from 0 to 0.35, alternatively from 0 to 0.25, alternatively from 0 to 0.15, and the sum of y'+z' is greater than zero and is typically from 0.2 to 0.99, alternatively from 0.5 to 0.95, alternatively from 0.65 to 0.9. Further, the sum of w'+x' can be zero but is typically from 0.01 to 0.80, alternatively from 0.05 to 0.5, alternatively from 0.1 to 0.35. Typically, 1 mol% to 30 mol%, alternatively 1 to 15 mol%, of the R⁶ groups in the silicone resin (A²) of the second embodiment are hydrogen, hydroxy, or a hydrolysable group.

Examples of condensation curable silicone resins (A²) of the second embodiment include, but are not limited to, silicone resins having the following formulae:

(Me(MeO)Si_{2/2})_{x'}(MeSiO_{3/2})_{y'},

(Ph(HO)SiO_{2/2})_{x'}(PhSiO_{3/2})_{y'},

(Me₃SiO_{1/2})_{w'}(CH₃COOSiO_{3/2})_{y'}(SiO_{4/2})_{z'},

(Ph(MeO)SiO_{2/2})_{x'}(MeSiO_{3/2})_{y'}(PhSiO_{3/2})_{y'},

(Ph(MeO)(HO)SiO_{1/2})_{w'}(MeSiO_{3/2})_{y'}(PhSiO_{3/2})_{y'}(Ph₂SiO_{2/2})_{x'}(PhMeSiO_{2/2})_{x'},

(PhMe(MeO)SiO_{1/2})_{w'}(Ph(HO)SiO_{2/2})_{x'}(MeSiO_{3/2})_{y'}(PhSiO_{3/2})_{y'}(PhMeSiO_{2/2})_{x'},

and

(Ph(HO)SiO_{2/2})_{x'}(PhSiO_{3/2})_{y'}(MeSiO_{3/2})_{y'}(PhMeSiO_{2/2})_{x'}

wherein Me is methyl, Ph is phenyl, wherein w', x', y', and z' are as defined above, and the subscript y' has a value such that the silicone resin has a number-average molecular weight of from 500 to 50,000. The sequence of units in the preceding formulae is not to be viewed in any way as limiting to the scope of the invention.

Specific examples of condensation curable silicone resins (A²) of the second embodiment include, but are not limited to, silicone resins having the following formulae:

(Me(MeO)Si_{2/2})_{0.05}(Me₃SiO_{1/2})_{0.75}(SiO_{4/2})_{0.2},

(Ph(HO)SiO_{2/2})_{0.09}(MeSiO_{3/2})_{0.67}(PhSiO_{3/2})_{0.24},

(Ph(MeO)SiO_{2/2})_{0.05}(MeSiO_{3/2})_{0.45}(PhSiO_{3/2})_{0.35}(Ph₂SiO_{2/2})_{0.1}(PhMeSiO_{2/2}) 0.05,

(PhMe(MeO)SiO_{1/2})_{0.02}(PhSiO_{3/2})_{0.4}(MeSiO_{3/2})_{0.45}(PhSiO_{3/2})_{0.1} (PhMeSiO_{2/2}) 0.03,

and

(Ph(HO)SiO_{2/2})_{0.04}(PhMe(MeO)SiO_{1/2})_{0.03}(PhSiO_{3/2})_{0.36}(MeSiO_{3/2})_{0.1} (PhMe SiO_{2/2})_{0.47}

wherein Me is methyl, Ph is phenyl, and the numerical subscripts outside the parenthesis denote mole fractions. The sequence of units in the preceding formulae is not to be viewed in any way as limiting to the scope of the invention.

As set forth above, the condensation curable silicone resin (A²) of the second embodiment typically has a number-average molecular weight (Mₙ) of from 500 to 50,000. Alternatively, the condensation curable silicone resin (A) may have a Mₙ of from 500 to 10,000, alternatively 800 to 3,000, where the molecular weight is determined by gel permeation chromatography employing a refractive index detector and silicone resin (MQ) standards.

The viscosity of the condensation curable silicone resin (A²) of the second embodiment at 25 °C is typically from 0.01 Pa·s to a solid, alternatively from 0.1 to 10,000 Pa·s, alternatively from 1 to 100 Pa·s. The condensation curable silicone resin (A) represented by formula (V) typically includes less than 20% (w/w), alternatively less than 10% (w/w), alternatively less than 2% (w/w), of silicon-bonded hydroxy groups, as determined by ²⁹Si NMR.

Methods of preparing silicone resins (A²) represented by formula (V) are well known in the art; many of these resins are commercially available. Silicone resins (A²) represented by formula (V) are typically prepared by cohydrolyzing the appropriate mixture of chlorosilane precursors in an organic solvent, such as toluene. For example, a silicone resin including R¹R⁶₂SiO_{1/2} units and R⁶SiO_{3/2} units can be prepared by cohydrolyzing a first compound having the formula R¹R⁶₂SiCl and a second compound having the formula R⁶SiCl₃ in toluene, where R¹ and R⁶ are as defined and exemplified above. The cohydrolyzing process is described above in terms of the hydrosilylation-curable silicone composition. The cohydrolyzed reactants can be further "bodied" to a desired extent to control the amount of crosslinkable groups and viscosity.

If desired, the silicone resins (A²) represented by formula (V) can be further treated with a condensation catalyst in an organic solvent to reduce the content of silicon-bonded hydroxy groups. Alternatively, first or second compounds containing hydrolysable groups other than chloro groups, such -Br, -I, -OCH₃, -OC(O)CH₃, - N(CH₃)₂, NHCOCH₃, and -SCH₃, can be co-hydrolyzed to form the silicone resin (A²). The properties of the silicone resin (A²) depend on the types of first and second compounds, the mole ratio of first and second compounds, the degree of condensation, and the processing conditions.

The Q units in formula (V) can be in the form of discrete particles in the silicone resin (A²). The particle size is typically from 1 nm to 20 µm. Examples of these particles include, but are not limited to, silica (SiO_{4/2}) particles of 15 nm in diameter.

In another embodiment, the condensation-curable silicone composition comprises a rubber-modified silicone resin (A³) prepared by reacting an organosilicon compound selected from (i) a silicone resin having the formula (R¹R⁶₂SiO_{1/2})_{w'}(R⁶₂SiO_{2/2})_{x'}(R⁶SiO_{3/2})_{y'}(SiO_{4/2})_{z'}, (ii) hydrolysable precursors of (i), and (iii) a silicone rubber having the formula R⁸₃SiO(R¹R⁸SiO)ₘSiR⁸₃ in the presence of water, (iv) a condensation catalyst, and (v) an organic solvent, wherein R¹ and R⁶ are as defined and exemplified above, R⁸ is R¹ or a hydrolysable group, m is from 2 to 1,000, alternatively from 4 to 500, alternatively from 8 to 400, and w', x', y', and z' are as defined and exemplified above. Silicone resin (i) has an average of at least two silicon-bonded hydroxy or hydrolysable groups per molecule. The silicone rubber (iii) has an average of at least two silicon-bonded hydrolysable groups per molecule. The mole ratio of silicon-bonded hydrolysable groups in the silicone rubber (iii) to silicon-bonded hydroxy or hydrolysable groups in the silicone resin (i) is from 0.01 to 1.5, alternatively from 0.05 to 0.8, alternatively from 0.2 to 0.5.

In a first embodiment, typically at least 1 mol%, alternatively at least 5 mol%, alternatively at least 10 mol% of the groups R⁶ in the silicone resin (i) are hydroxy or hydrolysable groups. In a second embodiment, typically 1 mol% to 30 mol%, or alternatively 1 to 15 mol% of the groups R⁶ in the silicone resin (i) are hydrogen, hydroxy, or a hydrolysable group.

The silicone resin (i) of the first embodiment typically has a number-average molecular weight (Mₙ) of at least 300, alternatively from 500 to 50,000, alternatively from 800 to 3,000, where the molecular weight is determined by gel permeation chromatography employing a low angle laser light scattering detector, or a refractive index detector and silicone resin (MQ) standards.

Specific examples of silicone resins suitable for use as silicone resin (i) include, but are not limited to, resins having the following formulae:

(Me(MeO)Si_{2/2})_{x'}(MeSiO_{3/2})_{y'}, (Ph(HO)SiO_{2/2})_{x'}(PhSiO_{3/2})_{y'}.

(Ph(MeO)SiO_{2/2})_{x'}(PhSiO_{3/2})_{y'}(MeSiO_{3/2})_{y'}(PhSi_{3/2})_{y'}(PhMeSiO_{2/2})_{x'},

and

(CH₃COOSiO_{3/2})_{y'}(PhSiO_{3/2})_{y'}(SiO_{4/2})_{z'}(Me₂SiO_{2/2})_{x'}(Ph₂SiO_{2/2})_{x'}

where Me is methyl, Ph is phenyl, where x', y', and z' are as defined above, and the subscript y' has a value such that the silicone resin has a number-average molecular weight of from 500 to 50,000. The sequence of units in the preceding formulae is not to be viewed in any way as limiting to the scope of the invention.

Other specific examples of silicone resins suitable for use as silicone resin (i) include, but are not limited to, resins having the following formulae:

(Ph(HO)SiO_{2/2})_{0.03}(PhSiO_{3/2})_{0.37}(MeSiO_{3/2})_{0.45}(PhSiO_{3/2})_{0.1} (PhMeSiO_{2/2})_{0.0 5}

and

(CH₃COOSiO_{3/2})_{0.06}(PhSiO_{3/2})_{0.3}(SiO_{4/2})_{0.04}(Mc₂SiO_{2/2})_{0.2}(Ph₂SiO_{2/2})_{0.4}

where Me is methyl, Ph is phenyl, the numerical subscripts outside the parenthesis denote mole fractions. The sequence of units in the preceding formulae is not to be viewed in any way as limiting to the scope of the invention. Silicone resin (i) can be a single silicone resin or a mixture comprising two or more different silicone resins, each having the specified formula. Silicone resin (i) can be a single silicone resin or a mixture comprising two or more different silicone resins, each having the specified formula.

As used herein, the term "hydrolysable precursors" refers to silanes having hydrolysable groups that are suitable for use as starting materials (precursors) for preparation of the silicone resin (i). The hydrolysable precursors (ii) can be represented by the formulae R¹R⁸₂SiX, R⁸₂SiX₂, R⁸SiX₃, and SiX₄, wherein R¹, R⁸, and X are as defined and exemplified above.

Specific examples of hydrolysable precursors (ii) include, but are not limited to, silanes having the formulae:

Me₂ViSiCl, Me₃SiCl, MeSi(OEt)₃, PhSiCl₃, MeSiCl₃, Me₂SiCl₂, PhMeSiCl₂, SiCl₄, Ph₂SiCl₂, PhSi(OMe)₃, MeSi(OMe)₃, PhMeSi(OMe)₂, and Si(OEt)₄,

wherein Me is methyl, Et is ethyl, and Ph is phenyl.

Specific examples of silicone rubbers (iii) include, but are not limited to, silicone rubbers having the following formulae:

(EtO)₃SiO(Me₂SiO)₅₅Si(OEt)₃,

(EtO)₃SiO(Me₂SiO)₁₆Si(OEt)₃,

(EtO)₃SiO(Me₂SiO)₃₈₆Si(OEt)₃, and (EtO)₂MeSiO(PhMeSiO)₁₀SiMe(OEt)₂,

wherein Me is methyl and Et is ethyl.

The reaction is typically carried out at a temperature of from room temperature (~23 ± 2°C) to 180°C, alternatively from room temperature to 100 °C.

The reaction time depends on several factors, including the structures of the silicone resin (i) and the silicone rubber (iii), and the temperature. The components are typically allowed to react for a period of time sufficient to complete the condensation reaction. This means the components are allowed to react until at least 40 mol%, alternatively at least 65 mol%, alternatively at least 90 mol%, of the silicon-bonded hydrolysable groups originally present in the silicone rubber (iii) have been consumed in the condensation reaction, as determined by ²⁹Si NMR spectrometry. The time of reaction is typically from 1 to 30 h at a temperature of from room temperature (∼23 ± 2 °C) to 100 °C. The optimum reaction time can be determined by routine experimentation.

Suitable condensation catalysts (iv) are described in further detail below, and suitable organic solvents (v) are described above in the context of rubber-modified silicone resin (A¹) above. The concentration of the condensation catalyst (iv) is sufficient to catalyze the condensation reaction of the silicone resin (i) with the silicone rubber (iii). Typically, the concentration of the condensation catalyst (iv) is from 0.01 to 5% (w/w), alternatively from 0.01 to 3% (w/w), alternatively from 0.05 to 2.5% (w/w), based on the weight of the silicon resin (i). The concentration of the organic solvent (v) is typically from 10 to 95% (w/w), alternatively from 20 to 85% (w/w), alternatively from 50 to 80% (w/w), based on the total weight of the reaction mixture.

The concentration of water in the reaction mixture depends on the nature of the groups R⁸ in the organosilicon compound and the nature of the silicon-bonded hydrolysable groups in the silicone rubber. When the silicone resin (i) contains hydrolysable groups, the concentration of water is sufficient to effect hydrolysis of the hydrolysable groups in the silicon resin (i) and the silicone rubber (iii). For example, the concentration of water is typically from 0.01 to 3 moles, alternatively from 0.05 to 1 moles, per mole of hydrolysable groups in the silicone resin (i) and the silicone rubber (iii) combined. When the silicone resin (i) does not contain hydrolysable groups, only a trace amount, e.g., 100 ppm, of water is typically present in the reaction mixture. Trace amounts of water are normally present in the reactants and/or solvent.

As set forth above, the condensation-curable silicone composition can further comprise the cross-linking agent (B¹). The cross-linking agent (B¹) can have the formula R⁷_{q}SiX_{4-q}, wherein R⁷ is C₁ to C₈ hydrocarbyl or C₁ to C₈ halogen-substituted hydrocarbyl, X is a hydrolysable group, and q is 0 or 1. The hydrocarbyl and halogen-substituted hydrocarbyl groups represented by R⁷, and the hydrolysable groups represented by X, are as described and exemplified above.

Specific examples of cross-linking agents (B¹) include, but are not limited to, alkoxy silanes such as MeSi(OCH₃)₃, CH₃Si(OCH₂CH₃)₃, CH₃Si(OCH₂CH₂CH₃)₃, CH₃Si[O(CH₂)₃CH₃]₃, CH₃CH₂Si(OCH₂CH₃)₃, C₆H₅Si(OCH₃)₃, C₆H₅CH₂Si(OCH₃)₃, C₆H₅Si(OCH₂CH₃)₃, CH₂=CHSi(OCH₃)₃, CH₂=CHCH₂Si(OCH₃)₃, CF₃CH₂CH₂Si(OCH₃)₃, CH₃Si(OCH₂CH₂OCH₃)₃, CF₃CH₂CH₂Si(OCH₂CH₂OCH₃)₃, CH₂=CHSi(OCH₂CH₂OCH₃)₃, CH₂=CHCH₂Si(OCH₂CH₂OCH₃)₃, C₆H₅Si(OCH₂CH₂OCH₃)₃, Si(OCH₃)₄, Si(OC₂H₅)₄, and Si(OC₃H₇)₄; organoacetoxysilanes such as CH₃Si(OCOCH₃)₃, CH₃CH₂Si(OCOCH₃)₃, and CH₂=CHSi(OCOCH₃)₃; organoiminooxysilanes such as CH₃Si[ON=C(CH₃)CH₂CH₃]₃, Si[O-N=C(CH₃)CH₂CH₃]₄, and CH₂=CHSi[ON=C(CH₃)CH₂CH₃]₃; organoacetamidosilanes such as CH₃Si[NHC(=O)CH₃]₃ and C₆H₅Si[NHC(=O)CH₃]₃; amino silanes such as CH₃Si[NH(s-C₄H₉)]₃ and CH₃Si(NHC₆H₁₁)₃; and organoaminooxysilanes.

The cross-linking agent (B¹) can be a single silane or a mixture of two or more different silanes, each as described above. Also, methods of preparing tri-and tetra-functional silanes are well known in the art; many of these silanes are commercially available.

When present, the concentration of the cross-linking agent (B¹) in the condensation-curable silicone composition is sufficient to cure (cross-link) the condensation-curable silicone resin. The exact amount of the cross-linking agent (B¹) depends on the desired extent of cure, which generally increases as the ratio of the number of moles of silicon-bonded hydrolysable groups in the cross-linking agent (B¹) to the number of moles of silicon-bonded hydrogen atoms, hydroxy groups, or hydrolysable groups in the silicone resin (A²) increases. Typically, the concentration of the cross-linking agent (B¹) is sufficient to provide from 0.2 to 4 moles of silicon-bonded hydrolysable groups per mole of silicon-bonded hydrogen atoms, hydroxy groups, or hydrolysable groups in the silicone resin (A²). The optimum amount of the cross-linking agent (B¹) can be readily determined by routine experimentation.

Condensation catalyst (C¹) can be any condensation catalyst typically used to promote condensation of silicon-bonded hydroxy (silanol) groups to form Si-O-Si linkages. Examples of condensation catalysts include, but are not limited to, amines; and complexes of lead, tin, zinc, and iron with carboxylic acids. In particular, the condensation catalyst (C¹) can be selected from tin(II) and tin(IV) compounds such as tin dilaurate, tin dioctoate, and tetrabutyl tin; and titanium compounds such as titanium tetrabutoxide.

When present, the concentration of the condensation catalyst (C¹) is typically from 0.1 to 10% (w/w), alternatively from 0.5 to 5% (w/w), alternatively from 1 to 3% (w/w), based on the total weight of the silicone resin (A²).

When the condensation-curable silicone composition includes the condensation catalyst (C¹), the condensation-curable silicone composition is typically a two-part composition where the silicone resin (A²) and condensation catalyst (C¹) are in separate parts.

The condensation-curable silicone composition can further contain inorganic fillers in particulate form, such as silica, alumina, calcium carbonate, and mica. In one embodiment, for example, the condensation-curable silicone composition further includes silica nanoparticles. The nanoparticles may help reduce the coefficient of thermal expansion of substrate 106. A low coefficient of thermal expansion may improve manufacturability of CIS-based photovoltaic devices 104. Nanoparticles may also increase mechanical strength of substrate 106. The silica nanoparticles can be any silica material having at least one physical dimension (e.g., particle diameter, layer thickness) less than about 200 nm. One particularly useful form of silica nanoparticles are fumed silica nanoparticles. Examples of useful commercially available unmodified silica starting materials include nano-sized colloidal silicas available under the product designations NALCO 1040, 1042, 1050, 1060, 2326, 2327, and 2329 colloidal silica from Nalco Chemical Co., Naperville, Illinois, Aerosil® from Degussa, Ludox® from DuPont, Snowtex® from Nissan Chemical, Levasil® from Bayer, or Sylysia® from Fuji Silysia Chemical. Suitable fumed silicas include for example, products commercially available from DeGussa AG, (Hanau, Germany) under the trade designation, "Aerosil series OX 50", as well as product numbers-130,-150, and-200. Fumed silicas are also commercially available from Cabot Corp., Tuscola, I, under the Bade designations CAB O-SPERSE 2095", "CAB-O-SPERSE A105", and "CAB-O-SIL M5". Those skilled in the art are aware of different well-established processes to access particles in different sizes, with different physical properties and with different compositions such as flame-hydrolysis (Aerosil-Process), plasma-process, arc-process and hot-wall reactor-process for gas-phase or solid-phase reactions or ionic-exchange processes and precipitation processes for solution-based reactions.

The silica nanoparticles may be in the form of a colloidal dispersion. The silica nanoparticles thus may be dispersed in a polar solvent such as methanol, ethanol, isopropyl alcohol (IPA), ketones such as methyl isobutyl ketone, water, acetic acid, diols and trials such as propylene glycol, 2-methyl-1,3-propane diol HOCH2CH(CH3)CH2OH, 1,2-hexanediol CH3(CH2)3CH(OH)CH2OH, and glycerol; glycerol esters such as glyceryl triacetate (triacetin), glyceryl tripropionate (tripropionin), and glyceryl tributyrate (tributyrin); and polyglycols such as polyethylene glycols and polypropylene glycols, among which are PPG-14 butyl ether C₄Hg(OCH(CH₃)CH₂)₁₄OH. Alternatively, the silica nanoparticles can also be dispersed in a non-polar solvent such as toluene, benzene, xylene, etc.

The silica particle size typically ranges from 1 to 1000 nm, or alternatively from 1 to 100 nm, or alternatively from 5 to 30 nm. The silica nanoparticles can be a single type of silica nanoparticles or a mixture comprising at least two different types of silica nanoparticles. It is known that silica nanoparticles may be of pure silicon dioxide, or they may contain a certain amount of impurities such as Al₂O₃, ZnO, and/or cations such as Na⁺, K⁺⁺, Ca⁺⁺, Mg⁺⁺, etc.

The concentration of the silica nanoparticles is typically from 0.0001 to 99 wt%, alternatively from 0.001 to 75 wt%, alternatively from 10 to 65 wt%, alternatively from 5 to 50 wt%, alternatively from 20 to 40 wt%, based on the total weight of the condensation-curable silicone composition. The condensation-curable silicone composition can be a one-part composition comprising the condensation-curable silicone resin (A² or A³), and any optional ingredients, and silica nanoparticles in a single part or, alternatively, a multi-part composition comprising these components in two or more parts.

The one-part condensation-curable silicone composition can be prepared by combining the condensation curable silicone resin (A² or A³), the silica nanoparticles, and any optional ingredients in the stated proportions at ambient temperature, with or without the aid of an organic solvent. Also, the silicone composition can be prepared by combining the components in each part. The condensation-curable silicone compositions including the silica nanoparticles can also be prepared in-situ, i.e., the silica nanoparticles can be added during the process to manufacture the condensation-curable silicone resin (A² or A³) described above. Mixing can be accomplished by any of the techniques known in the art such as milling, blending, and stirring, either in a batch or continuous process.

The condensation-curable silicone composition of the present invention can comprise additional ingredients, as known in the art and as described above for the hydrosilylation-curable silicone composition.

In yet another embodiment, the silicone composition may be a free radical-curable silicone composition. Examples of free radical-curable silicone compositions include peroxide-curable silicone compositions, radiation-curable silicone compositions containing a free radical photoinitiator, and high energy radiation-curable silicone compositions. Typically, the free radical-curable silicone composition comprises a silicone resin (A⁴) and, optionally, a cross-linking agent (B²) and/or a free radical initiator (C²) (e.g., a free radical photoinitiator or organic peroxide).

The silicone resin (A⁴) can be any silicone resin that can be cured (i.e., cross-linked) by at least one method selected from (i) exposing the silicone resin to radiation having a wavelength of from 150 to 800 nm in the presence of a free radical photoinitiator, (ii) heating the silicone resin (A⁴) in the presence of an organic peroxide, and (iii) exposing the silicone resin (A⁴) to an electron beam. The silicone resin (A⁴) is typically a copolymer containing T siloxane units and/or Q siloxane units in combination with M and/or D siloxane units.

For example, the silicone resin (A⁴) may have the formula (R¹R⁹₂SiO_{1/2})_{w"}(R⁹₂SiO_{2/2})_{x"}(R⁹SiO_{3/2})_{y"}(SiO_{4/2})_{z"}, wherein R¹ is as defined and exemplified above, R⁹ is R¹, alkenyl, or alkynyl, w" is from 0 to 0.99, x" is from 0 to 0.99, y" is from 0 to 0.99, z" is from 0 to 0.85, and w"+x"+y"+z" = 1.

The alkenyl groups represented by R⁹, which may be the same or different, are as defined and exemplified in the description of R² above.

The alkynyl groups represented by R⁹, which may be the same or different, typically have from 2 to about 10 carbon atoms, alternatively from 2 to 6 carbon atoms, and are exemplified by, but are not limited to, ethynyl, propynyl, butynyl, hexynyl, and octynyl.

The silicone resin (A⁴) typically has a number-average molecular weight (Mₙ) of at least 300, alternatively from 500 to 10,000, alternatively from 1,000 to 3,000, where the molecular weight is determined by gel permeation chromatography employing a refractive index detector and silicone resin (MQ) standards.

The silicone resin (A⁴) can contain less than 10% (w/w), alternatively less than 5% (w/w), alternatively less than 2% (w/w), of silicon-bonded hydroxy groups, as determined by ²⁹Si NMR.

Specific examples of silicone resins (A⁴) that are suitable for purposes of the present invention include, but are not limited to, silicone resins having the following formulae: (Vi₂MeSiO_{1/2})_{0.25}(PhsiO_{3/2})_{0.75}, (ViMe₂SiO_{1/2})_{0.25}(PhSiO_{3/2})_{0.75}, (ViMe₂SiO_{1/2})_{0.25}(MeSiO_{3/2})_{0.25}(PhSiO_{3/2})_{0.50}, (ViMe₂SiO_{1/2})_{0.15}(PhSiO_{3/2})_{0.75} (SiO_{4/2})_{0.1}, and (Vi₂MeSiO_{1/2})_{0.15}(ViMe₂SiO_{1/2})_{0.1}(PhSiO_{3/2})_{0.75},
wherein Me is methyl, Vi is vinyl, Ph is phenyl, and the numerical subscripts outside the parenthesis denote mole fractions. The sequence of units in the preceding formulae is not to be viewed in any way as limiting to the scope of the invention.

The free radical-curable silicone composition of the present method can comprise additional ingredients including, but not limited to, silicone rubbers; unsaturated compounds; free radical initiators; organic solvents; UV stabilizers; sensitizers; dyes; flame retardants; antioxidants; fillers, such as reinforcing fillers, extending fillers, and conductive fillers; and adhesion promoters.

The free radical-curable silicone composition can further comprise an unsaturated compound selected from (i) at least one organosilicon compound having at least one silicon-bonded alkenyl group per molecule, (ii) at least one organic compound having at least one aliphatic carbon-carbon double bond per molecule, and (iii) mixtures comprising (i) and (ii), wherein the unsaturated compound has a molecular weight less than 500. Alternatively, the unsaturated compound has a molecular weight of less than 400 or less than 300. Also, the unsaturated compound can have a linear, branched, or cyclic structure.

The organosilicon compound (i) can be an organosilane or an organosiloxane. The organosilane can be a monosilane, disilane, trisilane, or polysilane. Similarly, the organosiloxane can be a disiloxane, trisiloxane, or polysiloxane. Cyclosilanes and cyclosiloxanes typically have from 3 to 12 silicon atoms, alternatively from 3 to 10 silicon atoms, alternatively from 3 to 4 silicon atoms. In acyclic polysilanes and polysiloxanes, the silicon-bonded alkenyl group(s) can be located at terminal, pendant, or at both terminal and pendant positions.

Specific examples of organosilanes include, but are not limited to, silanes having the following formulae:
Vi₄Si, PhSiVi₃, MeSiVi₃, PhMeSiVi₂, Ph₂SiVi₂, and PhSi(CH₂CH=CH₂)₃,
wherein Me is methyl, Ph is phenyl, and Vi is vinyl.

Specific examples of organosiloxanes include, but are not limited to, siloxanes having the following formulae:
PhSi(OSiMe₂Vi)₃, Si(OSiMe₂Vi)₄, MeSi(OSiMe₂Vi)₃, and Ph₂Si(OSiMe₂Vi)₂,
wherein Me is methyl, Vi is vinyl, and Ph is phenyl.

The organic compound can be any organic compound containing at least one aliphatic carbon-carbon double bond per molecule, provided the compound does not prevent the silicone resin (A⁴) from curing to form a silicone resin film. The organic compound can be an alkene, a diene, a triene, or a polyene. Further, in acyclic organic compounds, the carbon-carbon double bond(s) can be located at terminal, pendant, or at both terminal and pendant positions.

The organic compound can contain one or more functional groups other than the aliphatic carbon-carbon double bond. Examples of suitable functional groups include, but are not limited to, -O-, >C=O, -CHO, -CO₂-, -C≡N, -NO₂, >C=C<, -C≡C-, -F, -Cl, -Br, and -I. The suitability of a particular unsaturated organic compound for use in the free-radical curable silicone composition of the present invention can be readily determined by routine experimentation.

The organic compound can be in a liquid or solid state at room temperature. Also, the organic compound can be soluble, partially soluble, or insoluble in the free-radical curable silicone composition. The normal boiling point of the organic compound, which depends on the molecular weight, structure, and number and nature of functional groups in the compound, can vary over a wide range. Typically, the organic compound has a normal boiling point greater than the cure temperature of the composition. Otherwise, appreciable amounts of the organic compound may be removed by volatilization during cure.

Examples of organic compounds containing aliphatic carbon-carbon double bonds include, but are not limited to, 1,4-divinylbenzene, 1,3-hexadienylbenzene, and 1,2-diethenylcyclobutane.

The unsaturated compound can be a single unsaturated compound or a mixture comprising two or more different unsaturated compounds, each as described above. For example, the unsaturated compound can be a single organosilane, a mixture of two different organosilanes, a single organosiloxane, a mixture of two different organosiloxanes, a mixture of an organosilane and an organosiloxane, a single organic compound, a mixture of two different organic compounds, a mixture of an organosilane and an organic compound, or a mixture of an organosiloxane and an organic compound.

The concentration of the unsaturated compound is typically from 0 to 70% (w/w), alternatively from 10 to 50% (w/w), alternatively from 20 to 40% (w/w), based on the total weight of the free radical-curable silicone composition.

Methods of preparing organosilanes and organosiloxanes containing silicon-bonded alkenyl groups, and organic compounds containing aliphatic carbon-carbon double bonds are well known in the art; many of these compounds are commercially available.

The free radical initiator is typically a free radical photoinitiator or an organic peroxide. Further, the free radical photoinitiator can be any free radical photoinitiator capable of initiating cure (cross-linking) of the silicone resin upon exposure to radiation having a wavelength of from 200 to 800 nm.

Examples of free radical photoinitiators include, but are not limited to, benzophenone; 4,4'-bis(dimethylamino)benzophenone; halogenated benzophenones; acetophenone; α-hydroxyacetophenone; chloro acetophenones, such as dichloroacetophenones and trichloroacetophenones; dialkoxyacetophenones, such as 2,2-diethoxyacetophenone; α-hydoxyalkylphenones, such as 2-hydroxy-2-methyl-1-phenyl-1-propanone and 1-hydroxycyclohexyl phenyl ketone; α-aminoalkylphenones, such as 2-methyl-4'-(methylthio)-2-morpholiniopropiophenone; benzoin; benzoin ethers, such as benzoin methyl ether, benzoin ethyl ether, and benzoin isobutyl ether; benzil ketals, such as 2,2-dimethoxy-2-phenylacetophenone; acylphosphinoxides, such as diphenyl(2,4,6-trimethylbenzoyl)phosphine oxide; xanthone derivatives; thioxanthone derivatives; fluorenone derivatives; methyl phenyl glyoxylate; acetonaphthone; anthraquinone derivatives; sufonyl chlorides of aromatic compounds; and O-acyl α-oximinoketones, such as 1-phenyl-1,2-propanedione-2-(O-ethoxycarbonyl)oxime.

The free radical photoinitiator can also be a polysilane, such as the phenylmethylpolysilanes defined by West in U.S. Pat. No. 4,260,780, the disclosure of which as it relates to the phenylmethylpolysilanes is hereby incorporated by reference; the aminated methylpolysilanes defined by Baney et al. in U.S. Pat. No. 4,314,956, the disclosure of which is hereby incorporated by reference as it relates to aminated methylpolysilanes; the methylpolysilanes defined by Peterson et al. in U.S. Pat. No. 4,276,424, the disclosure of which is hereby incorporated by reference as it relates to methylpolysilanes; and the polysilastyrene defined by West et al. in U.S. Pat. No. 4,324,901, the disclosure of which is hereby incorporated by reference as it relates to polysilastyrene.

The free radical photoinitiator can be a single free radical photoinitiator or a mixture comprising two or more different free radical photoinitiators. The concentration of the free radical photoinitiator is typically from 0.1 to 6% (w/w), alternatively from 1 to 3% (w/w), based on the weight of the silicone resin (A⁴).

The free radical initiator can also be an organic peroxide. Examples of organic peroxides include, diaroyl peroxides such as dibenzoyl peroxide, di-p-chlorobenzoyl peroxide, and bis-2,4-dichlorobenzoyl peroxide; dialkyl peroxides such as di-t-butyl peroxide and 2,5-dimethyl-2,5-di-(t-butylperoxy)hexane; diaralkyl peroxides such as dicumyl peroxide; alkyl aralkyl peroxides such as t-butyl cumyl peroxide and 1,4-bis(t-butylperoxyisopropyl)benzene; and alkyl aroyl peroxides such as t-butyl perbenzoate, t-butyl peracetate, and t-butyl peroctoate.

The organic peroxide can be a single peroxide or a mixture comprising two or more different organic peroxides. The concentration of the organic peroxide is typically from 0.1 to 5% (w/w), alternatively from 0.2 to 2% (w/w), based on the weight of the silicone resin (A⁴).

The free radical-curable silicone composition can further comprise at least one organic solvent. The organic solvent can be any aprotic or dipolar aprotic organic solvent that does not react with the silicone resin (A⁴) or additional ingredient(s) and is miscible with the silicone resin (A⁴). Examples of organic solvents include, but are not limited to, saturated aliphatic hydrocarbons such as n-pentane, hexane, n-heptane, isooctane and dodecane; cycloaliphatic hydrocarbons such as cyclopentane and cyclohexane; aromatic hydrocarbons such as benzene, toluene, xylene and mesitylene; cyclic ethers such as tetrahydrofuran (THF) and dioxane; ketones such as methyl isobutyl ketone (MIBK); halogenated alkanes such as trichloroethane; and halogenated aromatic hydrocarbons such as bromobenzene and chlorobenzene. The organic solvent can be a single organic solvent or a mixture comprising two or more different organic solvents, as described above.

The concentration of the organic solvent is typically from 0 to 99% (w/w), alternatively from 30 to 80% (w/w), alternatively from 45 to 60% (w/w), based on the total weight of the free radical-curable silicone composition.

When the free-radical curable silicone composition described above contains one or more additional ingredients, for example, a free radical initiator, the composition can be a one-part composition comprising the silicone resin and optional ingredient(s) in a single part, or a multi-part composition comprising the components in two or more parts.

Another suitable silicone composition comprises cyclic dihydrogenpolysiloxanes, which have a weight-average molecular weight ranging in value from 1,500 to 1,000,000, are liquid at room temperature (∼23 ± 2°C), and comprise H₂SiO_{2/2} units. The cyclic dihydrogenpolysiloxanes can be produced by subjecting dichlorosilane (H₂SiCl₂) to hydrolysis/condensation in a mixture of a non-polar organic solvent and water and removing volatile cyclic dihydrogenpolysiloxanes from the formed cyclic dihydrogenpolysiloxanes.

The non-polar organic solvents used herein are exemplified by aromatic hydrocarbon organic solvents and aliphatic hydrocarbon organic solvents, with the aromatic hydrocarbon organic solvents exemplified by toluene and xylene and the aliphatic hydrocarbon organic solvents exemplified by hexane, heptane, octane, and cyclohexane.

The hydrolysis/condensation reaction is typically conducted via slow dropwise addition of a non-polar organic solvent solution of dichlorosilane while stirring the non-polar organic solvent and water. It is preferred to conduct the dropwise addition at a temperature of not more than 5°C in order to prevent volatilization of the dihydrogenpolysiloxane.

The hydrolysis/condensation is typically conducted in a mixture of a non-polar organic solvent phase and an aqueous phase, followed by washing the non-polar organic solvent phase containing the formed cyclic dihydrogenpolysiloxane with water, drying it, and eluting the non-polar organic solvent and volatile cyclic dihydrogenpolysiloxanes.

Once the dropwise addition is complete, allowing the solution to stand causes it to separate into a non-polar organic solvent layer and an aqueous layer, after which the non-polar organic solvent layer is removed and washed with water. Typically, the non-polar organic solvent layer is washed until it becomes neutral or until chlorine ions are no longer detected. The non-polar organic solvent layer may also be washed to a certain extent and neutralized with a weak alkali, e.g. calcium carbonate, sodium carbonate, or sodium bicarbonate, followed by washing the formed salts with water. The washed non-polar organic solvent layer may be dried and the non-polar organic solvent and volatile cyclic dihydrogenpolysiloxanes are typically eluted. Although there are no particular limitations concerning the method used to dry the washed non-polar organic solvent layer so long as it does not alter the cyclic dihydrogenpolysiloxanes, a powdered or granulated drying agent, e.g. anhydrous magnesium sulfate, anhydrous sodium sulfate, or a molecular sieve, may be added. The resulting mixture is subjected to agitation, and the drying agent filtered off. There are also no particular limitations concerning elution of the non-polar organic solvent and cyclic dihydrogenpolysiloxane so long as the cyclic dihydrogenpolysiloxanes are not altered. Elution may be exemplified by heating under reduced pressure or blowing in dry nitrogen gas under heating. The volatile cyclic dihydrogenpolysiloxanes mentioned herein are 3-mers ∼ 15-mers. The fact that the product is a cyclic dihydrogenpolysiloxane is ascertained by the absence of silanol group absorption when analyzed using FT-IR

The cyclic dihydrogenpolysiloxanes can also be produced by subjecting dichlorosilane to co-hydrolysis/condensation in a mixture of the non-polar organic solvent, hydrochloric acid, and an ionic surface active agent, and removing volatile cyclic dihydrogenpolysiloxanes from the formed dihydrogenpolysiloxanes as described above. The hydrochloric acid is typically concentrated hydrochloric acid, and, more typically, hydrochloric acid with a hydrogen chloride content of 15 wt% to 37 wt%. The ionic surface active agents may include anionic surface active agents, cationic surface active agents, and amphoteric surface active agents, with the anionic surface active agents exemplified by alkali metal salts of aliphatic hydrocarbon sulfonic acids, e.g. alkali metal salts of alkylsulfonic acids of 6 to 20 carbon atoms, alkali metal salts of alkenesulfonic acids of 6 to 20 carbon atoms, and alkali metal salts of alkylbenzenesulfonic acids; aliphatic hydrocarbon sulfonic acids, e.g. alkylsulfonic acids of 6 to 20 carbon atoms, alkenesulfonic acids of 6 to 20 carbon atoms; alkylbenzenesulfonic acids; alkali metal salts of alkylsulfonic esters; and alkali metal salts of higher aliphatic acids. Sodium and potassium are preferred as the alkali metals used herein. The cationic surface active agents are exemplified by quaternary ammonium salts, e.g. tetramethylammonium chloride, benzyltributylammonium chloride, cetyltrimethylammonium chloride, and tetrabutylammonium chloride; and by alkylamine hydrochlorides, e.g. decylamine hydrochloride. The ionic surface active agents are typically used in an amount of from 0.01∼50 wt%; more typically from 0.1∼1.0 wt%, of the water contained in the hydrochloric acid.

Typically, the hydrolysis/condensation reaction is carried out via dropwise addition of the non-polar organic solvent solution containing dichlorosilane to a mixture including the non-polar organic solvent, hydrochloric acid, and the ionic surface active agent. Typically, agitation is continued during the dropwise addition. The hydrolysis/condensation reaction typically occurs at a temperature of not more than 5°C in order to prevent volatilization of the dichlorosilane.

Another suitable silicone composition comprises hydrogenpolysiloxanes having a siloxane unit formula of [H₂SiO_{2/2}]_{x"'}[HSiO_{3/2}]_{y"'} [SiO_{4/2}]_{z"'} where x"', y"', and z'" represent mole fractions, 0.12 ≤ x'''< 1.0, 0 ≤ y"' ≤ 0.88, 0 ≤ z''' ≤ 0.30, y''' and z''' are not simultaneously 0, and x'''+ y''' + z''' = 1. The hydrogenpolysiloxanes typically have a weight-average molecular weight ranging in value from 500 to 1,000,000 and are liquid at temperatures of 120°C or less.

When z''' = 0 in the siloxane unit formula [H₂SiO_{2/2}]_{x"'}[HSiO_{3/2}]y_{"'}[SiO_{4/2}]_{z"'}, the hydrogenpolysiloxanes is described by the siloxane unit formula [H₂SiO_{2/2}]_{x"'} [HSiO_{3/2}]_{y"'} wherein x'" and y'" represent mole fractions as set forth above and x'" + y"' = 1. When z'" = 0, typically 0.15 ≤ x"' < 1.0 and 0 < y"' ≤ 0.85 because when x'" is smaller than 0.15, the degree of branching increases and cracking becomes more likely to happen upon cure.

When y"' = 0 in the siloxane unit formula [H₂SiO_{2/2}]_{x"'}[HSiO_{3/2}]y_{"'}[SiO_{4/2}]_{z"'}, the hydrogenpolysiloxanes is described by the siloxane unit formula [H₂SiO_{2/2}]_{x"'}[SiO_{4/2}]_{z"'} wherein x'" and z'" represent mole fractions as set forth above and x"' + z'" = 1. When y"' = 0, typically 0.15 ≤ x'" <1.0 because when x'" is smaller than 0.15, the degree of branching increases and cracking becomes more likely to happen upon cure, and 0 < z'" ≤ 0.15 because when z"' is larger than 0.15, the degree of branching increases and cracking becomes more likely to happen upon cure.

On the average, the hydrogenpolysiloxanes have the above-mentioned siloxane unit formulas in mole fractions of x"', y"', and z"', which does not imply an arrangement in the order of the above-mentioned siloxane units. When siloxane units are arranged randomly in the hydrogenpolysiloxanes, there may be cases in which some block portions are present, but the rest of the units are arranged in a random fashion. Since [H₂SiO_{2/2}] units are always present, there may be linear blocks, but because there are always [HSiO_{3/2}] units and/or [SiO_{4/2}] units, the molecular structure is at least branched and may be network- or cage-like as well, i.e. it could be a resin. When the hydrogenpolysiloxanes have [SiO_{4/2}] units, the degree of branching increases even more.

The hydrogenpolysiloxanes can be produced by a process wherein (A') dichlorosilane (H₂SiCl₂), (B') trichlorosilane (HSiCl₃), and (C') tetraalkoxysilane (Si(OR)₄) or tetrachlorosilane (SiCl₄) are subjected to co-hydrolysis/condensation in mole ratios such that 0.12 ≤ (A') < 1.0,0 ≤ (B') ≤ 0.88, 0≤ (C') ≤ 0.30, (A') and (B') are not simultaneously 0, and (A') + (B') + (C') = 1 in a mixture of a non-polar organic solvent, hydrochloric acid, and an ionic surface active agent, whereupon the formed hydrogenpolysiloxane-containing non-polar organic solvent layer is washed with water, dried, and the non-polar organic solvent is eluted together with volatile hydrogenpolysiloxanes. In this instance, R stands for an alkyl group, typically ethyl, and can be a methyl or propyl group as well. The specific method steps are performed in the same manner as set forth above for the cyclic dihydrogenpotysiloxanes.

In addition, hydrogenpolysiloxanes of the siloxane unit formula [H₂SiO_{2/2}]x"' [HSiO_{3/2}]_{y"'} can be produced via co-hydrolysis of (A') dichlorosilane (H₂SiCl₂) and (B') trichlorosilane (HSiCl₃), and hydrogenpolysiloxanes of the siloxane unit formula [H₂SiO_{2/2]}x,"[SiO_{4/2}]z_{'"} (wherein x"' and z'" represent mole fractions, 0.12 ≤ x'" < 1.0, 0 < z"' ≤ 0.30, and x"' + z'" = 1) can be produced via co-hydrolysis of (A') dichlorosilane (H₂SiCl₂) and (C') tetraalkoxysilane (Si(OR)₄) or tetrachlorosilane (SiCl₄).

The hydrochloric acid is typically concentrated hydrochloric acid, and, even more typically, hydrochloric acid with a hydrogen chloride content of 15 wt% to 37 wt%. Because water contained in the hydrochloric acid is used for the hydrolysis of (A') dichlorosilane (H₂SiCl₂), (B') trichlorosilane (HSiCl₃), and (C') tetraalkoxysilane (Si(OR)₄) or tetrachlorosilane (SiCl₄), the hydrochloric acid is typically used in an amount that is equal to or higher than the equimolar amount necessary for the hydrolysis of (A') dichlorosilane (H₂SiCl₂), (B') trichlorosilane (HSiCl₃), and (C') tetraalkoxysilane (Si(OR)₄) or tetrachlorosilane (SiCl₄).

The ionic surface active agents are described above and suppress gelling due to independent condensation and rapid hydrolysis/condensation of trichlorosilane and promote its co-hydrolysis/condensation with dichlorosilane.

When the cyclic dihydrogenpolysiloxanes, as well as the hydrogenpolysiloxanes that have the siloxane unit formula of [H₂SiO_{2/2]x"'} [HSiO_{3/2}]_{y"'} [SiO_{4/2}]_{z"'}, are heated to a temperature of 120°C or higher, silicon-bonded hydrogen is turned into hydroxyl groups via an oxidation reaction and crosslinking takes place as a result of a dehydration condensation reaction with the silicon-bonded hydrogen atoms. In other words, crosslinking and curing take place as a result of forming Si-O-Si bonds. In wet ammonia, hydrogen atoms directly bonded to silicon become activated and turn into hydroxyl groups by readily reacting with moisture in the air, thereby causing a dehydration condensation reaction with silicon-bonded hydrogen atoms and cross-linking. As a result, silica (silicon oxide) is formed. However, there is no need to eliminate all hydrogen atoms directly bonded to silicon atoms in the molecules of the above-mentioned cyclic dihydrogenpolysiloxanes and the above-mentioned hydrogenpolysiloxanes and some of the hydrogen atoms, for instance, 60 mol% or less, may be left intact.

The heating may occur in an oxygen atmosphere. Air is a representative example of the oxygen atmosphere. The oxygen atmosphere may alternatively be an oxygen gas-containing nitrogen gas or helium gas with an oxygen concentration lower than that of air. Alternatively, exposure to ozone, nitrous oxide, or wet ammonia may be used to induce reaction of the cyclic dihydrogenpolysiloxanes and hydrogenpolysiloxanes. The ozone is exemplified by pure ozone, ozone-containing air, steam-containing ozone, and ozone-containing nitrogen gas, any of which can be used. The reaction, when induced by ozone, occurs in a more efficient manner than when the reaction is induced by atmospheric oxygen. The nitrous oxide is exemplified by pure nitrous oxide gas, nitrous oxide-containing air, and nitrous oxide-containing nitrogen gas, any of which can be used. The wet ammonia is exemplified by ammonia-containing air, ammonium hydroxide gas, and nitrogen gas containing ammonia and steam, any of which can be used. The exposure to ozone, exposure to nitrous oxide, or exposure to ammonia may be carried out under heating.

The above-mentioned cyclic dihydrogenpolysiloxanes and hydrogenpolysiloxanes may also be cured by high-energy irradiation. Electron beams and X-rays are representative examples of such irradiation. The amount of electron beam irradiation is typically not less than 3 Gry.

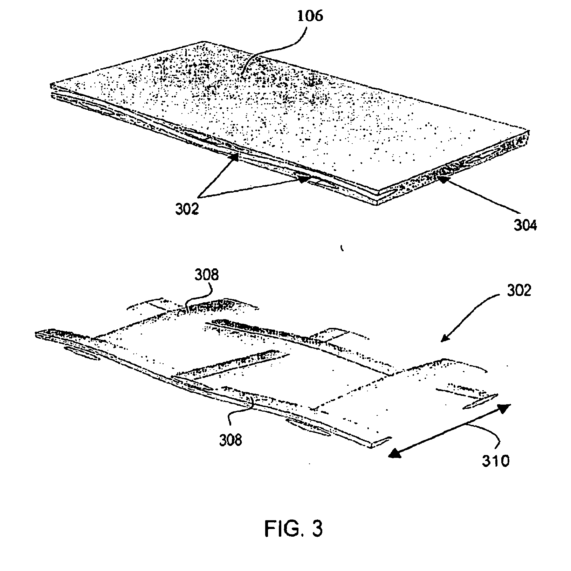

Referring to Figure 3, the substrate **106** may further include a fiber reinforcement **302.** The fiber reinforcement **302** may enhance mechanical strength of the substrate **106** and may reduce the coefficient of thermal expansion of the cured silicone composition **304** in the substrate **106,** thereby improving manufacturability of the CIS-based photovoltaic devices **104.**

The fiber reinforcement **302** can be any reinforcement comprising fibers. Typically, the fiber reinforcement **302** typically has a high modulus and high tensile strength. The fiber reinforcement **302** typically has a Young's modulus at 25 °C of at least 3 GPa. For example, the fiber reinforcement **302** typically has a Young's modulus at 25 °C of from 3 to 1,000 GPa, alternatively from 3 to 200 GPa, alternatively from 10 to 100 GPa. Moreover, the fiber reinforcement **302** typically has a tensile strength at 25°C of at least 50 MPa. For example, the reinforcement typically has a tensile strength at 25°C of from 50 to 10,000 MPa, alternatively from 50 to 1,000 MPa, alternatively from 50 to 500 MPa.

The fiber reinforcement **302** can be a woven fabric, e.g., a cloth; a nonwoven fabric, e.g., a mat or roving; or loose (individual) fibers. In a non-limiting example, the fiber reinforcement **302** has a width **310** of 100 µm to 200 µm, and a thickness of 20 µm to 40 µm. The fibers **308** in the reinforcement **302** are typically cylindrical in shape and have a diameter of from 1 to 100 µm, alternatively from 1 to 20 µm, alternatively form 1 to 10 µm. Loose fibers are typically continuous, meaning the fibers **308** extend throughout the substrate **106** in a generally unbroken manner. Fibers with oblong cross-sectional shape can also be used.

The fiber reinforcement **302** is typically heat-treated prior to use to remove organic contaminants. For example, the fiber reinforcement **302** is typically heated in air at an elevated temperature, for example, 575°C. for a suitable period of time, for example 2 h.

Specific examples of fiber reinforcements **302** that are suitable for purposes of the present invention include, but are not limited to, reinforcements comprising glass fibers; quartz fibers; graphite fibers; nylon fibers; polyester fibers; aramid fibers, such as Kevlar® and Nomex®; polyethylene fibers; polypropylene fibers; and silicon carbide fibers.

In addition to the fiber reinforcement **302,** the substrate **106** can further include one or more nano fillers, such as the silica nanoparticles set forth above, to mitigate thermal cracking and to increase mechanical integrity. The fiber reinforcement **302** provides a macro-scale continuous reinforcement, and the nano filler provides a nano-scale discontinuous reinforcement. The fiber reinforcement **302** and the nano fillers work together to maximize resistance to stress in the substrate **106.** Resistance to stress enables the substrate **106** to withstand the annealing temperatures in excess of 500 °C without exhibiting substantial cracking.

Suitable nano fillers that may be included in the substrate **106** include, but are not limited to, functionalized carbon nanofiber; aluminum-based fillers such as aluminum oxide and aluminum trihydroxide; boron-based fillers such as boric oxide and boric acid; mica; colloidal silica, and combinations thereof. The silica nanoparticles set forth above are also suitable nano fillers, especially for condensation-curable silicone compositions. Typically, the nano fillers have a diameter of less than 1 µm, typically less than **200** nm. A specific example of a suitable nano filler for purposes of the present invention is Pyrograph III carbon nanofiber commercially available from Applied Sciences, Inc. of Cedarville, OH.

The fiber reinforcement **302** can be impregnated with the silicone composition. The nano fillers are typically mixed into the silicone resin using conventional mixing Methods prior to impregnating the fiber reinforcement **302** with the silicone composition. The fiber reinforcement **302** can be impregnated with the silicone composition using a variety of methods. For example, the silicone composition, as described above, may be applied to a release liner to form a silicone film. The silicone composition can be applied to the release liner using conventional coating techniques, such as spin coating, dipping, spraying, brushing, or screenprinting. The silicone composition is typically applied in an amount sufficient to embed the fiber reinforcement **302** therein. The release liner can be any rigid or flexible material having a surface from which the substrate **106** can be removed without damage by delamination after the silicone composition is cured. Examples of release liners include, but are not limited to, nylon, polyethyleneterephthalate, and polyimide.

The fiber reinforcement **302** is then embedded in the silicone film, thereby forming an embedded fiber reinforcement **302.** The fiber reinforcement **302** can be embedded in the silicone film by simply placing the reinforcement on the silicone film and allowing the silicone composition to saturate the reinforcement. However, it is to be appreciated that the fiber reinforcement **302** may be first deposited on the release liner, followed by the application of the silicone composition onto the fiber reinforcement **302.** In another embodiment, when the fiber reinforcement **302** is woven or nonwoven fabric, the reinforcement can be impregnated with the silicone composition by passing the fiber reinforcement **302** through the silicone composition without the used of the release liner. The fabric is typically passed through the silicone composition at a rate of from 1 to 1,000 cm/s at room temperature (-23 ± 2 °C).

The embedded fiber reinforcement **302** is then typically degassed. The embedded fiber reinforcement **302** can be degassed by subjecting it to a vacuum at a temperature of from room temperature (-23 ± 2 °C) to 60 °C, for a period of time sufficient to remove entrapped air. For example, the embedded fiber reinforcement **302** can typically be degassed by subjecting the embedded fiber reinforcement **302** to a pressure of from 1,000 to 20,000 Pa for 5 to 60 minutes at room temperature.

After degassing, additional silicone composition may be applied to the embedded fiber reinforcement **302** to form an impregnated fiber reinforcement 302. The silicone composition can be applied to the degassed embedded fiber reinforcement **302** using conventional methods, as described above. Additional cycles of degassing and application of silicone composition may also occur.

The impregnated fiber reinforcement **302** may also be compressed to remove excess silicone composition and/or entrapped air, and to reduce the thickness of the impregnated fiber reinforcement **302.** The impregnated fiber reinforcement **302** can be compressed using conventional equipment such as a stainless steel roller, hydraulic press, rubber roller, or laminating roll set. The impregnated fiber reinforcement **302** is typically compressed at a pressure of from 1,000 Pa to 10 MPa and at a temperature of from room temperature (~23 ± 2 °C) to 50 °C.

Typically, the silicone composition in the impregnated fiber reinforcement **302** is then cured to form the substrate **106.** "Cured" as defined herein means that the silicone composition, which can be in the form of the component parts, a mixture, a solution, or a blend, is exposed to room temperature air, heated at elevated temperatures, or exposed to UV, electron beam, or microwave. Heating can occur using any known conventional means such as by placing the silicone composition or, in this case, the impregnated fiber reinforcement **302,** into an air circulating oven. The impregnated fiber reinforcement **302** can be heated at atmospheric, sub-atmospheric, or supra-atmospheric pressure. The impregnated fiber reinforcement **302** is typically heated at a temperature of from room temperature (~23 ± 2°C) to 250 °C, alternatively from room temperature to 200 °C, alternatively from room temperature to 150 °C, at atmospheric pressure. The impregnated fiber reinforcement **302** is heated for a length of time sufficient to cure (cross-link) the silicone composition. For example, the impregnated fiber reinforcement **302** is typically heated at a temperature of from 150 to 200°C for a period of from 0.1 to 3 h.

Alternatively, the impregnated fiber reinforcement **302** can be heated in a vacuum at a temperature of from 100 to 200 °C and a pressure of from 1,000 to 20,000 Pa for a time of from 0.5 to 3 h to form the reinforced silicone film. The impregnated fiber reinforcement **302** can be heated in the vacuum using a conventional vacuum bagging process. In a typical process, a bleeder (e.g., polyester) is applied over the impregnated fiber reinforcement **302,** a breather (e.g., nylon, polyester) is applied over the bleeder, a vacuum bagging film (e.g., nylon) equipped with a vacuum nozzle is applied over the breather, the assembly is sealed with tape, a vacuum (e.g., 1,000 Pa) is applied to the sealed assembly, and the evacuated bag is heated as described above.

The substrate **106** of the present invention typically comprises, on a pre-curing weight basis, from 10 to 99% (w/w), alternatively from 30 to 95% (w/w), alternatively from 60 to 95% (w/w), alternatively from 80 to 95% (w/w), of the silicone composition. The fiber reinforcement **302** is typically present in the substrate **106** in an amount of at least 5 % (w/w), more typically in an amount of from 20 to 50 % (w/w). The nano filler is typically present in the substrate **106** in an amount of at least 0.003% (w/w), alternatively from 0.003 to 20% (w/w), alternatively from 0.003 to 0.2% (w/w).

The substrate **106** typically has a thickness of from 15 to 500 µm, alternatively from 15 to 300 µm, alternatively from 20 to 300 µm, alternatively from 25 to 200 µm.

Among other excellent physical properties, the substrate **106** typically has a flexibility such that the substrate **106** can be bent over a cylindrical steel mandrel having a diameter less than or equal to 3.2 mm without cracking, where the flexibility is determined as described in ASTM Standard D522-93a, Method B.

The substrate **106** typically has a low coefficient of linear thermal expansion (CTE), high tensile strength, and a high modulus. For example the substrate **106** typically has a CTE of from 0 to 80, µm/m°C, alternatively from 0 to 20µm/m°C, alternatively from 2 to 10µm/m°C, at temperatures of from room temperature (-23 ± 2 °C) to 200°C. Also, the substrate **106** typically has a tensile strength at 25 - °C of from 50 to 200 MPa, alternatively from 80 to 200 MPa, alternatively from 100 to 200 MPa. Further, the substrate **106** typically has a Young's modulus at 25 °C of from 2 to 10 GPa, alternatively from 2 to 6 GPa, alternatively from 3 to 5 GPa.

The transparency of the substrate **106** depends on a number of factors, such as the composition of the cured silicone composition, the thickness of the substrate **106,** and the refractive index of the fiber reinforcement **302.** The substrate **106** typically has a transparency (% transmittance) of at least 15%, alternatively at least 60%, alternatively at least 75%, alternatively at least 85%, in the visible region of the electromagnetic spectrum.

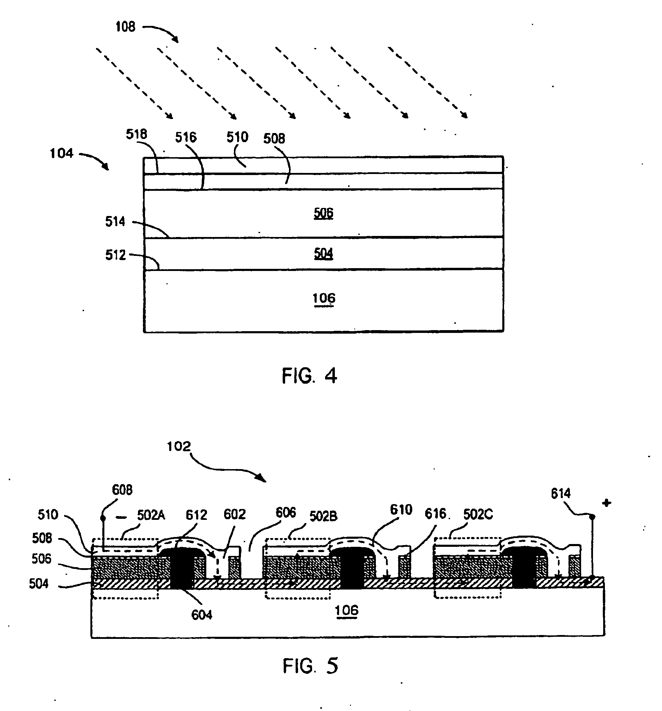

Referring to Figure 4, the CIS-based photovoltaic device **104** includes a vertical stack of typically four to seven thin film layers that are formed on the substrate **106.** Thus, while only four layers are shown on the substrate **106** in Figure 4, it is to be appreciated that additional optional layers, to be described below, may also be included. The various layers are typically deposited or modified in separate chambers.

To prepare the CIS-base photovoltaic device **104,** the substrate **106** is provided. The substrate **106** may be provided by preparing the substrate **106** as set forth above. Alternatively, the substrate **106** may be obtained from a third party. Typically, a bare starter roll, or strip, of the substrate **106** may be supplied from a pay-out roll. This substrate **106** typically has a width of about 33 cm, a thickness of about 0.005 cm, and a length of up to about 300 meters. The width, thickness and length dimensions are, of course, matters of choice, depending on the ultimate intended application for the CIS-based photovoltaic device **104.**

A stress-compliant metal interlayer (not shown), chosen to have intermediate thermal expansion characteristics between the substrate **106** and subsequently-formed layer(s) of molybdenum **504,** can be optionally utilized as a first layer formed on a top surface 512 of the substrate **106.** The metal interlayer may be formed from materials selected from the group of nickel vanadium, copper, brass, indium tin oxide (ITO), as well as other materials known in the art to have minimal detrimental effects on the CIS-based device **104** should the material diffuse to other layers within the device **104.** The metal interlayer may be used to enhance adhesion and minimize cracking of the subsequently-formed layer(s) of molybdenum **504.**

After optional formation of the first layer, at least one layer of molybdenum (Mo) **504** possessing a certain level of desirable internal compressive stress and optionally containing entrained oxygen is formed. The layer(s) of molybdenum **504** may alternatively be formed directly on the top surface **512** of the substrate **106** when the first layer is absent, in which case the layer(s) of molybdenum **504** typically contain entrained oxygen to alter properties of the layer(s) of molybdenum **504** and to reduce cracking of the layer(s) of molybdenum **504.** The layer(s) of molybdenum **504** functions as a back contact layer for the CIS-based device **104.** The layer(s) of molybdenum **504** may be about 0.5 µm thick. Optionally, an additional stress relief layer (not shown) formed from molybdenum other another inert metal may be formed on an opposite side of the substrate **106** from the layer(s) of molybdenum **504.**

The CIS-based solar absorber layer **506** is then formed on the substrate **106.** More specifically, the CIS-based solar absorber layer **506** is typically formed on a top surface **514** of the layer(s) of molybdenum **504** through methods that are known in the art. CIS, as used herein, refers to copper-indium-diselenide with or without metal alloys, such as gallium, aluminum, boron, tellurium or sulfur. For example, the CIS-based solar absorber layer **506** may be copper-indium-gallium-diselenide (CIGS). These different compositions, among others, can be used essentially interchangeably as an absorber layer depending on the particular properties desired in the CIS-based photovoltaic device **104.** By way of example and not of limitation, the CIS-based solar absorber layer **506** may be about 2.0 µm thick. As known in the art, the CIS-based solar absorber layers are best formed by heating at temperatures in excess of 500 °C for a period of from 25 to 30 minutes. More typically, the devices are subjected to heating at a temperature of about 575 °C in order to anneal the layers. Because the substrate **106** of the present invention may withstand temperatures in excess of 500 °C, conversion efficiency of the CIS-based devices in generating electricity is maximized.

A heterojunction partner or window layer **508** is formed on a top surface **516** of the CIS-based solar absorber layer **506.** The window layer **508** is typically formed from cadmium-sulfide (CdS), CdS alloyed with zinc (ZnCdS), zinc sulfide, zinc oxide and zinc hydroxide, or zinc-magnesium oxide and zinc or magnesium hydroxide. The window layer **508** is typically formed by chemical bath deposition (CBD), but can also be formed by non-wet techniques such as sputtering. By way of example and not of limitation, the window layer **508** may be about 0.05 µm thick.

Optionally, an electrically insulating layer (not shown) is formed on a top surface **518** of the window layer **508.** By way of example and not of limitation, the electrically insulating layer may be about 0.05 µm thick and may be formed from an intrinsic zinc-oxide (i-ZnO), a zinc-magnesium oxide alloy, or, tin oxide. Use of such layers is known in the art.

A top contact layer **510** in the form of a semi-transparent, conductive-oxide is formed either directly on the top surface **518** of the window layer **508** if no electrically insulating layer is used, or directly on the electrically insulating layer when present. The top contact layer **510** is typically formed from a doped tin oxide, an indium-tin oxide (ITO) alloy, doped zinc-oxide using aluminum or gallium (ZnO:Al,Ga), or tin oxide. By way of example and not of limitation, the top contact layer **510** may be about 0.6 µm thick.

In one embodiment, a back contact interface layer (not shown) may be formed between the layer(s) of molybdenum **504** and the CIS-based solar absorber layer **506.** The back contact interface layer may be formed from doped zinc-tellurium (ZnTe). In this embodiment, both the electrically insulating layer and the top contact layer **510** may be formed from tin oxide. Additional details regarding the inclusion of a back contact interface layer and forming both the top contact layer and the electrically insulating layer of tin oxide are taught in Ilvydas Matulionis, Sijin Han, Jennifer A. Drayton, Kent J. Price, and Alvin D. Compaan, Mat. Res. Soc. Symp. Proc. Vol. 668, p.H8.23.1, April (2001), which is herein incorporated by reference in its entirety.

In one embodiment of the present invention, a metallic grid (not shown), typically comprising a thin layer of Ni and a thicker layer of Al or Ag, is formed on the transparent conductive-oxide layer.

A wide variety of deposition processes may be used to form the various layers on the substrate **106.** For example, the deposition process may be a plasma sputter (RF, AC, DC, optionally plasma enhanced) technique, evaporation (thermal, electron beam, or cathodic arc) processing, chemical vapor-deposition (low pressure, atmospheric pressure, or plasma enhanced), a sublimation process, a physical vapor deposition process, and/or a hot wire process.

Sputtering may be accomplished under a pressure ranging from approximately one to twenty millitorr. A hollow cathode sputter or a cathodic arc technique may be accomplished under a pressure ranging from approximately one tenth to twenty millitorr. Evaporation pressures may range from approximately 0.01 to 0.1 millitorr. Chemical vapor and plasma enhanced chemical vapor deposition pressures may range from approximately 10 millitorr to atmospheric pressure. By way of example and not of limitation, power sources for RF, AC, and DC sputtering may range from approximately 50 Watts to 5,000 Watts on an approximately 60 square centimeter target. The axis of rotation distance may be approximately 2.25 inches. By way of example and not of limitation, individual or multiple electron beam pocket sources or a single linear beam evaporation trough may be utilized.

In one specific embodiment, the layer(s) of molybdenum **504** are formed on the substrate **106** or an interface layer using a DC sputtering process under a pressure ranging from approximately one to twenty millitorr. By way of example and not of limitation, power sources for DC sputtering may range from approximately 500 to 5,000 Watts on an approximately 60 square centimeter target. Oxygen may be incorporated into the layer(s) of molybdenum **504** during the sputter deposition process, as disclosed by Shafarman et al, at the Space Photovoltaic Research and Technology Conference at NASA Glenn in Cleveland, OH, September 2005.

In one specific embodiment, the CIS-based solar absorber layer **506** is formed on the layer(s) of molybdenum **504** using a thermal co-evaporation process. The thermal co-evaporation process may be conducted using a variety of methods that are known in the art, such as those disclosed in U.S. Patent No. 5,441,897 to Noufi et al., or in U.S. Patent No. 4,335,226 to Mickelsen et al.

In one specific embodiment, the window layer **508** is formed on the CIS-based solar absorber layer **506** using a chemical bath deposition process, a chemical surface deposition process, or a non-wet process such as sputtering. The chemical bath deposition process may be accomplished by a variety of methods that are known in the art. For example, U.S. Patent No. 6,537,845, to McCandless et al. discloses a method for applying a CdS bath solution on the first surface **516** of the CIS-based solar absorber layer. Also, as is known in the art, the window layer **508,** when formed from CdS, may be formed on the CIS-based solar absorber layer **506** by submersion into an aqueous chemical bath. Such chemical bath constituents typically include a cadmium salt and/or zinc salt, (NH₂)₂CS (which is commonly referred to as thiourea), a hydroxide agent, and water. Exemplary salts include cadmium sulfate, and zinc sulfate, and an example of the hydroxide agent is ammonium hydroxide (NH₄OH). The bath temperature is typically in the range of 60 to 85°C. Typically, the top surface **516** of the CIS-based solar absorber layer **506** is first submersed into a solution containing the salt(s) and the hydroxide agent for a sufficient amount of time (e.g., 1 minute) for the substrate **106** including the CIS-based solar absorber layer **506** to reach a desired temperature. Thiourea is then applied, and a chemical reaction is allowed to take place for several minutes. The substrate **106** including the CIS-based solar absorber layer **506** is removed from the chemical bath, and unreacted bath solution is rinsed away from the first surface **516** of the solar absorber layer **506.** The thickness of the resulting window layer **508** is typically in the range of 10 to 100 nm.

In one embodiment, a high-temperature chemical treatment is performed on junction materials (e.g., solar absorber layer **506**/window layer **508** heterojunctions) or solely on the solar absorber layer **506.** Such high temperature chemical treatment may be a wet or dry CdCl₂ application and subsequent application of high-temperatures (e.g., 350 to 450 °C) to the substrate with the CdCl₂ for a period of 5 to 30 minutes.

In one specific embodiment, the electrically insulating layer is formed on the window layer **508** using pulsed DC or RF sputtering under a pressure ranging from approximately one to twenty millitorr. By way of example and not of limitation, power sources for the pulsed DC sputtering may range from approximately 50 to 500 Watts on an approximately 60 square centimeter target. The electrically insulating layer formed by such sputtering may have a thickness in the range of from 10 to 100 nm.

In one specific embodiment, the top contact layer **510** may be formed on the window layer **506** or the electrically insulating layer using pulsed DC sputtering under a pressure ranging from approximately one to twenty millitorr. By way of example and not of limitation, power sources for the pulsed DC sputtering may range from approximately 500 to 1,500 Watts on an approximately 60 square centimeter target. A typical film thickness of the top contact layer formed by such sputtering may range from 200 to 500 nm.

In one embodiment of the present invention, as shown in Figure 5 CIS-based photovoltaic devices may be "monolithically integrated" on a common substrate **106.** In particular, the monolithic integration results in the array **102** with a plurality of photovoltaic devices **502A, 502B, 502C** monolithically integrated on the substrate **106.** It is to be appreciated that the array 102 may comprise any quantity of photovoltaic devices comprising a plurality of junctions.

In Figure 5, while all of the CIS-based devices **502** have a common substrate **106,** each CIS-based photovoltaic device **502** is electrically separated from one or more adjacent CIS-based photovoltaic devices **502** by first scribes **604.** Each first scribe **604** may be filled with resistive filler **612** to electrically isolate two sections of a given CIS-based photovoltaic device **502,** for example. Stated differently, each CIS-based photovoltaic device **502** includes a section of layer(s) of molybdenum **504,** solar absorber layer **506,** window layer **508,** and top contact layer **510,** with the substrate 106 common for each of the devices **502.** Furthermore, each device **502** includes a first scribe **604** down to the substrate **106** and each first scribe **604** is filled with resistive filler to enable the first scribe **604** to provide electrical isolation between the devices **502.** By way of example and not of limitation, the resistive filler may be a resistive ink or oxide.

In one embodiment, photovoltaic devices **502A, 502B, 502C** are electrically connected such that electric current **610** flows in series through photovoltaic devices **502.** As shown in Figure 5, electric current **610** may enter the array **102** via a terminal **608.** In the embodiment shown in Figure 5, electric current **610** flows from the terminal **608** along the top of photovoltaic device **502A** via the top contact layer **510.** Electric current **610** then flows from the top contact layer **510** to the layer(s) of molybdenum **504** via a second scribe **602,** which is filled with a conductive material used to form the top contact layer **510.** Next, electric current **610** flows through the layer(s) of molybdenum **504** to the next photovoltaic device, i.e., photovoltaic device **502B.** Electric current **610** then flows from the layer(s) of molybdenum **504** to the top contact layer **510** of photovoltaic device **502B** via the CIS-based solar absorber layer **506** and the window layer **508.** Electric current **610** continues to flow through the remainder of photovoltaic device **502B** in the same manner as it did in photovoltaic device **502A** and then flows through photovoltaic device **502C** in the same manner. Electric current finally exits the array **102** via another terminal **614.** While the embodiment shown in Figure 5 shows the photovoltaic devices **502A, 502B, 502C** connected in series, it is to appreciated that the photovoltaic devices **502A, 502B, 502C** may be connected in parallel or in a combination of in series and in parallel.

To prepare the array **102** shown in Figure 5, a series of scribing and printing operations interspersed with the deposition operations described above may be used to form a sequence of the monolithically integrated photovoltaic devices **104** on a single section of substrate **106,** thereby forming the array **102.**

After formation of the layer(s) of molybdenum **504,** CIS-based solar absorber layer **506,** and optionally window layer **508** and other optional layers set forth above, the substrate **106** typically proceeds through a sequence of operations designed to first divide, then subsequently, serially connect adjacent 'divided' areas. A first scribe operation is to scribe through all deposited layers exposing bare, uncoated substrate **106,** thereby forming first scribes **604.** This first scribe operation functionally divides the deposited layers into plural individual segments and thereby isolates each segment electrically. The segments are held together by the substrate **106,** which remains intact. The scribing technique used is a matter of design choice, with the preferred method herein accomplished using a high power density laser.

Directly adjacent to the first scribe operation, a second selective scribe operation is typically conducted to form second scribes **602.** In contrast to the first scribes **604,** the second scribes **602** are only cut down to the top surface **514** of the layer(s) of molybdenum **504,** thereby leaving the layer(s) of molybdenum **504** intact in the as-deposited conditions. This second selective scribe operation forms the second scribes **602,** which will be later filled in with a conductive oxide or material of choice used to form the top contact layer **510.** As can be seen in Figure 5, the first scribes **604** extend down to the substrate **106,** while the second scribes **602** extend only to the layer(s) of molybdenum **504.**

To prevent the conductive oxide in the top contact layer from filling in' the first scribe, and in effect reconnecting adjacent divided layers of molybdenum **504,** the first scribes **604** are typically filled in with an insulator. Typically, this is accomplished with a UV curable ink deposited with a commercially adapted ink jet dispense head that is coincident with the high power density laser. In an optional step, the electrically insulating layer is formed on the window layer **508** or on the CIS-based solar absorber layer **506** if a window layer **508** is not already formed.

The top contact layer **510** is then formed to a three dimensional top surface **616** after scribing. Finally, third scribes **606** are cut. As can be seen in Figure 5, the third scribes **606** extend to the top surface **514** of the layer(s) of molybdenum **504.** The third scribes **606** also provide electrically isolation to complete formation of an array **102** of the photovoltaic devices **502A, 502B, 502C.**

The CIS-based photovoltaic devices **104** of the present invention are capable of having an efficiency of up to, and may be in excess of, 19%. Although efficiency of up to 19% can be achieved using the substrate **106** of the present invention, experimentation is required to obtain process conditions that result in maximized efficiency.

The following examples are meant to illustrate the invention and are not to be viewed in any way as limiting to the scope of the invention.

### Example 1

### preparation of fiber reinforced substrates from MP101 Crystal Coat resin

A four-inch wide saturation trough was used. Style 106 glass fabric, obtained from BGF Industries and heat cleaned in air, was cut into strips 15" X 3.5" in size. Approximately 7 ml of the MP101 resin, available from SDC Technologies, Inc., was placed in the saturation tough and the glass fabric was drawn through the resin solution to form an impregnated fiber reinforcement. The impregnated fiber reinforcement was hung vertically in a fumed hood to dry and then transferred to an air-circulating oven to cure. The impregnated fiber reinforcement was partially cured at 50 °C for 10 min. and then impregnated again with the same resin. After drying, the impregnated fiber reinforcement was cured by the following procedure: 1 °C/min. to 75 °C, 75 °C/1 h., 1 °C/min. to 100 °C, 100 °C/1 h., 1 °C/min. to 125 °C, and 125 °C/1 h to form the fiber reinforced substrate. The fiber reinforced substrate was kept in the switched off oven to cool.

### Example 2

### Preparation and properties of fiber reinforced substrates from the MP101 Crystal Coat resin and 0.2 wt % treated Pyrograf III

0.031 grams of oxidized Pyrograf III was mixed into 50 grams of MP101 Crystal Coat resin in a glass vial and placed in a Bransonic ultrasonic cleaning bath and dispersed for 30 minutes. The mixture was then centrifuged if there was undispersed powder and the top dispersion was taken for film preparation.

The Style 106 glass fabric was heat, cleaned, and cut into a shape that would fit into the saturation pan. The mixture of the Pyrograf III and MP101 Crystal Coat resin was placed in the saturation pan, and the fabric was passed through the mixture in the saturation pan to form an impregnated fiber reinforcement. The impregnated fiber reinforcement was hung vertically in a fumed hood to dry and then transferred to an air-circulating oven to cure by the following procedure: 1 °C/min. to 75 °C, 75 °C/1 h., 1 °C/min. to 100 °C, 100 °C/1 h., 1 °C/min. to 125 °C, and 125 °C/1 h to form the fiber reinforced substrate. The fiber reinforced substrate was kept in the switched off oven to cool.

### Example 3

### Fabrication and testing of CIGS (copper indium gallium diselenide)-based photovoltaic devices on substrates prepared from Example 1.

An approximately 0.5 micrometer thick layer of molybdenum was sputtered onto the fiber reinforced substrate prepared in Example 1. Copper, indium, and gallium were co-evaporated onto the layer of molybdenum in a selenium atmosphere at a deposition substrate temperature of about 575°C for 20 minutes to form a CIS-based solar absorber layer having a thickness of about two micrometer thick. A 50 nm layer of CdS was then deposited onto the CIGS layer through a wet CBD bath process to form a window layer. A ZnO electrically insulating layer and an ITO top contact layer were sputtered onto the window layer and then nickel-silver grids were evaporated onto the top contact layer. The cell performance was tested under AM 1.5 illumination condition and an efficiency of 1 to 2% was measured.

### Example 4

### Fabrication and testing of CIGS (copper indium gallium diselenide)-based photovoltaic devices on film prepared from Example 2.

CIGS-based photovoltaic devices were fabricated in the same way as described in Example 3 on substrates prepared in Example 2. The CIGS-based photovoltaic devices were tested under the same conditions as shown in Example 3. An efficiency of 6 to 9% was measured.

The invention has been described in an illustrative manner, and it is to be appreciated that the terminology which has been used is intended to be in the nature of words of description rather than of limitation. Obviously, many modifications and variations of the present invention are possible in view of the above teachings. It is, therefore, to be appreciated that within the scope of the claims the invention may be practiced otherwise than as specifically described.

## Claims

1. A copper indium diselenide (CIS)-based photovoltaic device **(104)** comprising: a substrate (106);
and a CIS-based solar absorber layer **(506)** comprising copper, indium, and selenium formed on the substrate (106),
**characterized in that** the substrate **(106)** is formed from a silicone composition and comprises a fiber reinforcement.

2. A copper indium diselenide-based photovoltaic device **(104)** as set forth in claim 1 wherein said CIS-based solar absorber layer **(506)** further comprises a metal selected from the group of gallium, aluminum, boron, tellurium, sulfur, and combinations thereof.

3. A copper indium diselenide-based photovoltaic device **(104)** as set forth in any preceding claim wherein said silicone composition is further defined as a hydrosilylation-curable silicone composition comprising:
(A) a silicone resin having silicone-bonded alkenyl groups or silicon-bonded hydrogen;
(B) an organosilicon compound having an average of at least two silicon-bonded hydrogen atoms or silicon-bonded alkenyl groups per molecule, and present in an amount sufficient to cure said silicone resin; and
(C) a catalytic amount of a hydrosilylation catalyst.

4. A copper indium diselenide-based photovoltaic device **(104)** as set forth in claim 3 wherein said silicone resin has the formula:
(R¹R²₂SiO_{1/2})_{w}(R²₂SiO_{2/2})ₓ (R²SiO_{3/2})_{y}(SiO_{4/2})_{z}
wherein R¹ is a C₁ to C₁₀ hydrocarbyl group or a C₁ to C₁₀ halogen-substituted hydrocarbyl group, both free of aliphatic unsaturation, R² is R¹, an alkenyl group, or hydrogen, w is from 0 to 0.9, x is from 0 to 0.9, y is from 0 to 0.99, z is from 0 to 0.85, w+x+y+z=1, y+z/(w+x+y+z) is from 0.1 to 0.99, and w+x/(w+x+y+z) is from 0.01 to 0.9, provided said silicone resin has an average of at least two silicon-bonded alkenyl groups per molecule.

5. A copper indium diselenide-based photovoltaic device **(104)** as set forth in claim 3 wherein said silicone resin is further defined as a rubber-modified silicone resin comprising the reaction product of:
(A) a silicone resin having the formula:
(R¹R²₂SiO_{1/2})_{w}(R²₂SiO_{2/2})ₓ(R²SiO_{3/2})_{y}(SiO_{4/2})_{z},
and
(D) at least one silicone rubber selected from rubbers having the formula:
R⁵R¹₂SiO(R¹R⁵SiO)_{c}SiR¹₂R⁵,
and
R¹R²₂SiO(R²₂SiO)_{d}SiR²₂R¹,
wherein R¹ is a C₁ to C₁₀ hydrocarbyl group or a C₁ to C₁₀ halogen-substituted hydrocarbyl group, both free of aliphatic unsaturation, R² is R¹, an alkenyl group, or hydrogen, R⁵ is R¹ or -H, w is from 0 to 0.9, x is from 0 to 0.9, y is from 0 to 0.99, z is from 0 to 0.85, w+x+y+z=1, y+z/(w+x+y+z) is from 0.1 to 0.99, and w+x/(w+x+y+z) is from 0.01 to 0.9, provided said silicone resin has an average of at least two silicon-bonded alkenyl groups per molecule, (C) and (D) each have a value of from 4 to 1000,
in the presence of the hydrosilylation catalyst (c) and,
optionally, in the presence of an organic solvent, provided that when said silicone resin (A) silicon-bonded alkenyl groups, (D) has silicon-bonded hydrogen atoms, and when said silicone resin (A) silicon-bonded hydrogen atoms, (D) has silicon-bonded alkenyl groups.

6. A copper indium diselenide-based photovoltaic device **(104)** as set forth in any one of claims 1 or 2 wherein said silicone composition is further defined as a condensation-curable silicone composition comprising:
(A²) a silicone resin having at least two of a silicon-bonded hydroxy group or a hydrolysable group;
optionally, (B¹) a cross-linking agent having silicon-bonded hydrolysable groups, and
optionally, (C¹) a catalytic amount of a condensation catalyst.

7. A copper indium diselenide-based photovoltaic device **(104)** as set forth in claim 6 wherein said silicone resin has the formula:
(R¹R⁶₂SiO_{1/2})_{w'}(R⁶₂SiO_{2/2})_{x'}(R⁶SiO_{3/2})_{y'}(SiO_{4/2})_{z'}
wherein R¹ is a C₁ to C₁₀ hydrocarbyl group or a C₁ to C₁₀ halogen-substituted hydrocarbyl group, both free of aliphatic unsaturation, R⁶ is R¹, -H, -OH, or a hydrolysable group, w' is from 0 to 0.8, x' is from 0 to 0.95, y' is from 0 to 1, z' is from 0 to 0.99, w'+x'+y'+z'=1, provided said silicone resin (A²) has an average of at least two silicon-bonded hydrogen atoms, hydroxy groups, or hydrolysable groups per molecule.

8. A copper indium diselenide-based photovoltaic device **(104)** as set forth in claim 6 wherein said silicone resin has the formula:
(R¹R⁶₂SiO_{1/2})_{w'}(R⁶₂SiO_{2/2})_{x'}(R⁶SiO_{3/2})_{y'}(SiO_{4/2})_{z'}
wherein R¹ is a C₁ to C₁₀ hydrocarbyl group or a C₁ to C₁₀ halogen-substituted hydrocarbyl group, both free of aliphatic unsaturation, R⁶ is R¹, -H, -OH, or a hydrolysable group, w' is from 0 to 0.8, x' is from 0 to 0.95, y' is from 0 to 1, z' is from 0 to 0.99, w'+x'+y'+z'=1, provided silicone resin (A²) has an average of at least two silicon-bonded hydrogen atoms, hydroxy groups, or hydrolysable groups per molecule with the proviso that the sum of R¹SiO_{3/2} units and SiO_{4/2} units is greater than zero.

9. A copper indium diselenide-based photovoltaic device **(104)** as set forth in any one of claims1 or 2 wherein said silicone composition is further defined as a condensation-curable silicone composition comprising:
(A³) a rubber-modified silicone resin prepared by reacting an organosilicon compound selected from:
(i) a silicone resin having the formula
(R¹ R⁶₂SiO_{1/2})_{w'}(R⁶₂SiO_{2/2})_{x'}(R⁶SiO_{3/2})_{y},(SiO_{4/2})_{z'},
(ii) hydrolysable precursors of (i), and
(iii) a silicone rubber having the formula R⁸₃SiO(R¹R⁸SiO)ₘSiR⁸₃; in the presence of water, a condensation catalyst, and an organic solvent, wherein R¹ is a C₁ to C₁₀ hydrocarbyl group or a C₁ to C₁₀ halogen-substituted hydrocarbyl group, both free of aliphatic unsaturation, R⁶ is R¹, -H, -OH, or a hydrolysable group, R⁸ is R¹ or a hydrolysable group, m is from 2 to 1,000, w' is from 0 to 0.8, x' is from 0 to 0.95, y' is from 0 to 1, z' is from 0 to 0.99, w'+x'+y'+z'=1,
optionally, (B¹) a cross-linking agent having silicon-bonded hydrolysable groups, and
optionally, (C¹) a catalytic amount of a condensation catalyst.

10. A copper indium diselenide-based photovoltaic device **(104)** as set forth in any one of claims 1 or 2 wherein said silicone composition is further defined as a free radical-curable silicone composition comprising a silicone resin having the formula:
(R¹ R⁹₂SiO_{1/2})_{w"}(R⁹₂SiO_{2/2})_{x"}(R⁹SiO_{3/2})_{y"}(SiO_{4/2})_{z"},
wherein R¹ is C₁ to C₁₀ hydrocarbyl or C₁ to C₁₀ halogen-substituted hydrocarbyl, both free of aliphatic unsaturation; R⁹ is R¹, alkenyl, or alkynyl; w" is from 0 to 0.99; x" is from 0 to 0.99;' y" is from 0 to 0.99; z" is from 0 to 0.85; and w"+x"+y"+z"=1.

11. A copper indium diselenide-based photovoltaic device **(104)** as set forth in any one of claims 1 or 2 wherein said silicone composition comprises cyclic dihydrogenpolysiloxanes comprising H₂SiO_{2/2} units and having a weight-average molecular weight ranging in value from 1,500 to 1,000,000 and which are liquid at room temperature.

12. A copper indium diselenide-based photovoltaic device **(104)** as set forth in any one of claims 1 or 2 wherein said silicone composition comprises hydrogenpolysiloxanes having a siloxane unit formula of [H₂SiO_{2/2}]_{x"'}[HSiO_{3/2}]_{y"'}[SiO_{4/2}]_{z"'} where x"', y"', and z'" represent mole fractions, 0.12 ≤ x'" < 1.0, 0 ≤ y"' ≤ 0.88, 0 ≤ z"' ≤ 0.30, y'" and z"' are not simultaneously 0, and x"' + y"' + Z"' = 1.

13. A copper indium diselenide-based photovoltaic device **(104)** as set forth in any preceding claim wherein said substrate **(106)** further comprises a nano filler.

14. An array **(102)** including a plurality of said copper indium diselenide-based photovoltaic devices **(104)** set forth in any preceding claim.

15. A method of preparing a copper indium diselenide-based device **(104)** comprising the steps of:
providing a substrate **(106);**
forming a CIS-based solar absorber layer **(506)** comprising copper, indium, and selenium on the substrate **(106)**
**characterized in that** the substrate **(106)** is formed from a silicone composition and comprises a fiber reinforcement.

## Patentansprüche

1. Kupfer-Indium-Diselenid (CIS)-basierte photovoltaische Vorrichtung (104), umfassend: ein Substrat (106);
und eine CIS-basierte-Solarabsorber-Schicht (506), die Kupfer, Indium und Selen umfasst, ausgebildet auf dem Substrat (106),
**dadurch gekennzeichnet, dass** das Substrat (106) aus einer Silikonzusammensetzung gebildet ist und eine Faserverstärkung umfasst.

2. Kupfer-Indium-Diselenid-basierte photovoltaische Vorrichtung (104) gemäß Anspruch 1, wobei die CIS-basierte Solarabsorberschicht (506) außerdem ein Metall, ausgewählt aus der Gruppe von Gallium, Aluminium, Bor, Tellur, Schwefel und Kombinationen davon, umfasst.

3. Kupfer-Indium-Diselenid-basierte photovoltaische Vorrichtung (104) gemäß einem vorangehenden Anspruch, wobei die Silikonzusammensetzung weiter als eine durch Hydrosilylierung härtbare Silikonzusammensetzung definiert ist, umfassend:
(A) ein Silikonharz, das Silikon-gebundene Alkenylgruppen oder Silicium-gebundenen Wasserstoff hat;
(B) eine Organosiliciumverbindung, die im Durchschnitt wenigstens zwei Silicium-gebundene Wasserstoffatome oder Silicium-gebundene Alkenylgruppen pro Molekül hat und in einer Menge vorliegt, die ausreichend ist, um das Silikonharz zu härten, und
(C) eine katalytische Menge eines Hydrosilylierungskatalysators.

4. Kupfer-Indium-Diselenid-basierte photovoltaische Vorrichtung (104) gemäß Anspruch 3, wobei das Silikonharz die Formel:
(R¹R²₂SiO1_{½})_{w} (R²₂SiO_{2/2})ₓ (R₂SiO_{3/2})_{y} (SiO_{4/2})_{z}
hat, worin R¹ eine (C₁ bis C₁₀) -Hydrocarbylgruppe oder eine halogensubstituierte (C₁ bis C₁₀)-Hydrocarbylgruppe, beide frei von aliphatischer Ungesättigtheit, ist, R² R¹, eine Alkenylgruppe oder Wasserstoff ist, w 0 bis 0,9 ist, x 0 bis 0,9 ist, y 0 bis 0,99 ist, z 0 bis 0,85 ist, w+x+y+z=1, y+z/(w+x+y+z) 0,1 bis 0,99 ist und w+x/(w+x+y+z) 0,01 bis 0,9 ist, mit der Maßgabe, dass das Silikonharz einen Durchschnitt von wenigstens zwei Silicium-gebundenen Alkenylgruppen pro Molekül hat.

5. Kupfer-Indium-Diselenid-basierte photovoltaische Vorrichtung (104) gemäß Anspruch 3, wobei das Silikonharz außerdem als ein Kautschuk-modifiziertes Silikonharz definiert ist, umfassend das Reaktionsprodukt von:
(A) einem Silikonharz mit der Formel:
(R¹R²₂SiO_{1/2})_{w} (R²₂SiO_{2/2})ₓ (R²SiO_{3/2})_{y} (SiO_{4/2})_{z}
und
(D) wenigstens einem Silikonkautschuk, ausgewählt aus Kautschuken mit der Formel:
R⁵R¹₂SiO (R¹R⁵SiO)_{c}SiR¹₂R⁵
und
R¹R²₂SiO (R²₂SiO)_{d}SiR²₂R¹,
worin R¹ eine (C₁ bis C₁₀)-Hydrocarbylgruppe oder eine halogensubstituierte (C₁ bis C₁₀)-Hydrocarbylgruppe, beide frei von aliphatischer Ungesättigtheit, ist, R² R¹, eine Alkenylgruppe oder Wasserstoff ist, R⁵ R¹ oder -H ist, w 0 bis 0,9 ist, x 0 bis 0,9 ist, y 0 bis 0,99 ist, z 0 bis 0,85 ist, w+x+y+z=1, y+z/(w+x+y+z) 0,1 bis 0,99 ist und w+x/(w+x+y+z) 0,01 bis 0,9 ist, mit der Maßgabe, dass das Silikonharz einen Durchschnitt von wenigstens zwei Silicium-gebundenen Alkenylgruppen pro Molekül hat, wobei (C) und (D) jeweils einen Wert von 4 bis 1000 haben,
in Gegenwart des Hydrosilylierungskatalysators (c) und gegebenenfalls in Gegenwart eines organischen Lösungsmittels, mit der Maßgabe, dass, wenn das Silikonharz (A) Silicium-gebundene Alkenylgruppen hat, (D) Silicium-gebundene Wasserstoffatome hat, und wenn das Silikonharz (A) Silicium-gebundene Wasserstoffatome hat, (D) Silicium-gebundene Alkenylgruppen hat.

6. Kupfer-Indium-Diselenid-basierte photovoltaische Vorrichtung (104) gemäß einem der Ansprüche 1 oder 2, wobei die Silikonzusammensetzung außerdem als eine durch Kondensation härtbare Silikonzusammensetzung definiert ist, umfassend:
(A²) ein Silikonharz, das wenigstens zwei von einer Silicium-gebundenen Hydroxygruppe oder einer hydrolysierbaren Gruppe hat;
gegebenenfalls (B¹) ein Vernetzungsmittel, das Silicium-gebundene hydrolysierbare Gruppen hat, und
gegebenenfalls (C¹) eine katalytische Menge eines Kondensationskatalysators.

7. Kupfer-Indium-Diselenid-basierte photovoltaische Vorrichtung (104) gemäß Anspruch 6, wobei das Silikonharz die Formel:
(R¹R⁶₂SiO_{1/2})_{w'} (R⁶₂SiO_{2/2})_{x'} (R⁶SiO_{3/2})_{y'} (SiO_{4/2})_{z'}
hat, worin R¹ eine (C₁ bis C₁₀)-Hydrocarbylgruppe oder eine halogensubstituierte (C₁ bis C₁₀)-Hydrocarbylgruppe, beide frei von aliphatischer Ungesättigtheit, ist, R⁶ R¹, -H, -OH oder eine hydrolysierbare Gruppe ist, w' 0 bis 0,8 ist, x' 0 bis 0,95 ist, y' 0 bis 1 ist, z' 0 bis 0,99 ist, w' +x' +y' +z' =1, mit der Maßgabe, dass das Silikonharz (A²) einen Durchschnitt von wenigstens zwei Silicium-gebundenen Wasserstoffatomen, Hydroxygruppen oder hydrolysierbaren Gruppen pro Molekül hat.

8. Kupfer-Indium-Diselenid-basierte photovoltaische Vorrichtung (104) gemäß Anspruch 6, wobei das Silikonharz die Formel:
(R¹R⁶₂SiO_{1/2})_{w'} (R⁶₂SiO_{2/2})_{x'} (R⁶SiO_{3/2})_{y'} (SiO_{4/2})_{z'}
hat, worin R¹ eine (C₁ bis C₁₀)-Hydrocarbylgruppe oder eine halogensubstituierte (C₁ bis C₁₀)-Hydrocarbylgruppe, beide frei von aliphatischer Ungesättigtheit, ist, R⁶ R¹, -H, -OH oder eine hydrolysierbare Gruppe ist, w' 0 bis 0,8 ist, x' 0 bis 0,95 ist, y' 0 bis 1 ist, z' 0 bis 0,99 ist, w' +x' +y' +z' =1, mit der Maßgabe, dass Silikonharz (A²) einen Durchschnitt von wenigstens zwei Silicium-gebundenen Wasserstoffatomen, Hydroxygruppen oder hydrolysierbaren Gruppen pro Molekül hat, mit der Maßgabe, dass die Summe von R¹SiO_{3/2}-Einheiten und SiO_{4/2}-Einheiten größer als Null ist.

9. Kupfer-Indium-Diselenid-basierte photovoltaische Vorrichtung (104) gemäß einem der Ansprüche 1 oder 2, wobei die Silikonzusammensetzung außerdem als eine durch Kondensation härtbare Silikonzusammensetzung definiert ist, umfassend:
(A³) ein Kautschuk-modifiziertes Silikonharz, hergestellt durch Umsetzen einer Organosiliciumverbindung, ausgewählt aus:
(i) einem Silikonharz mit der Formel
(R¹R⁶₂SiO_{1/2})_{w'} (R⁶₂SiO_{2/2})_{x'} (R⁶SiO_{3/2})_{y'} (SiO_{4/2})_{z',}
(ii) hydrolysierbaren Vorläufern von (i) und
(iii) einem Silikonkautschuk mit der Formel
R⁸₃SiO(R¹R⁸SiO)ₘSiR⁸₃
in Gegenwart von Wasser, einem Kondensationskatalysator und einem organischen Lösungsmittel,
worin R¹ eine (C₁ bis C₁₀)-Hydrocarbylgruppe oder eine halogensubstituierte (C₁ bis C₁₀)-Hydrocarbylgruppe, beide frei von aliphatischer Ungesättigtheit, ist, R⁶ R¹, -H, -OH oder eine hydrolysierbare Gruppe ist, R⁸ R¹ oder eine hydrolysierbare Gruppe ist, m 2 bis 1000 ist, w' 0 bis 0,8 ist, x' 0 bis 0,95 ist, y' 0 bis 1 ist, z' 0 bis 0,99 ist, w'+x'+y'+z'=1;
gegebenenfalls (B¹) ein Vernetzungsmittel, das Silicium-gebundene hydrolysierbare Gruppen hat, und
gegebenenfalls (C¹) eine katalytische Menge eines Kondensationskatalysators.

10. Kupfer-Indium-Diselenid-basierte photovoltaische Vorrichtung (104) gemäß einem der Ansprüche 1 oder 2, wobei die Silikonzusammensetzung außerdem als eine durch freie Radikale härtbare Silikonzusammensetzung definiert ist, umfassend ein Silikonharz mit der Formel:
(R¹R⁹₂SiO_{1/2})_{w"} (R⁹₂SiO_{2/2})_{x"} (R⁹SiO_{3/2})_{y"} (SiO_{4/2})_{z"}
worin R¹ (C₁ bis C₁₀)-Hydrocarbyl oder halogensubstituiertes (C₁ bis C₁₀)-Hydrocarbyl, beide frei von aliphatischer Ungesättigtheit, ist; R⁹ R¹, Alkenyl oder Alkinyl ist; w" 0 bis 0,99 ist; x" 0 bis 0,99 ist; y" 0 bis 0,99 ist; z" 0 bis 0,85 ist und w" +x" +y" +z" =1.

11. Kupfer-Indium-Diselenid-basierte photovoltaische Vorrichtung (104) gemäß einem der Ansprüche 1 oder 2, wobei die Silikonzusammensetzung cyclische Dihydrogenpolysiloxane umfasst, die H₂SiO_{2/2}-Einheiten umfassen und ein gewichtsmittleres Molekulargewicht im Bereich von 1500 bis 1000000 haben und die bei Raumtemperatur flüssig sind.

12. Kupfer-Indium-Diselenid-basierte photovoltaische Vorrichtung (104) gemäß einem der Ansprüche 1 oder 2, wobei die Silikonzusammensetzung Hydrogenpolysiloxane umfasst, die eine Siloxaneinheit der Formel [H₂SiO_{2/2}]_{x"'} [HSiO_{3/2}] _{y"'} [SiO_{4/2}]_{z"} haben, worin x"', y"' und z"' Molfraktionen darstellen, 0,12 ≤ x'" < 1,0, 0 ≤ y"' ≤ 0,88, 0 ≤ z"' ≤ 0,30, y"' und z"' nicht gleichzeitig 0 sind und x"' +y"' +z"' =1.

13. Kupfer-Indium-Diselenid-basierte photovoltaische Vorrichtung (104) gemäß einem vorangehenden Anspruch, wobei das Substrat (106) außerdem einen Nanofüllstoff umfasst.

14. Array (102), umfassend eine Vielzahl der Kupfer-Indium-Diselenid-basierten photovoltaischen Vorrichtungen (104) gemäß einem vorangehenden Anspruch.

15. Verfahren zur Herstellung einer Kupfer-Indium-Diselenidbasierten Vorrichtung (104), umfassend die Schritte:
Bereitstellen eines Substrats (106);
Bilden einer CIS-basierten Solarabsorberschicht (506), umfassend Kupfer, Indium und Selen, auf dem Substrat (106),
**dadurch gekennzeichnet, dass** das Substrat (106) aus einer Silikonzusammensetzung gebildet wird und eine Faserverstärkung umfasst.

## Revendications

1. Dispositif photovoltaïque à base de diséléniure de cuivre-indium (CIS) (104) comprenant :
un substrat (106) ;
et une couche d'absorption solaire à base de CIS (506) comprenant du cuivre, de l'indium, et du sélénium formée sur le substrat (106),
**caractérisé en ce que** le substrat (106) est formé à partir d'une composition de silicone et comprenant un renfort de fibre.

2. Dispositif photovoltaïque à base de diséléniure de cuivre-indium (104) selon la revendication 1, dans lequel ladite couche d'absorption solaire à base de CIS (506) comprend en outre un métal sélectionné parmi le groupe constitué de gallium, aluminium, bore, tellure, soufre, et des associations de ceux-ci.

3. Dispositif photovoltaïque à base de diséléniure de cuivre-indium (104) selon l'une quelconque des revendications précédentes, dans lequel ladite composition de silicone est en outre définie en tant que composition de silicone pouvant être traitée par hydrosilylation comprenant :
(A) une résine de silicone possédant des groupes alcényles liés au silicium ou de l'hydrogène lié au silicium ;
(B) un composé d'organosilicium possédant une moyenne d'au moins deux atomes d'hydrogène liés au silicium ou groupes alcényles liés au silicium par molécule, et présent dans une quantité suffisante pour durcir ladite résine de silicone ; et
(C) une quantité catalytique d'un catalyseur d'hydrosilylation.

4. Dispositif photovoltaïque à base de diséléniure de cuivre-indium (104) selon la revendication 3, dans lequel ladite résine de silicone présente la formule :
(R¹R²₂SiO_{1/2})_{w}(R²₂SiO_{2/2})ₓ(R₂SiO_{3/2})_{y}(SiO_{4/2})_{z}
où R¹ est un groupe hydrocarbyle C₁ à C₁₀ ou un groupe hydrocarbyle substitué par halogène C₁ à C₁₀, tous les deux dépourvus d'insaturation aliphatique, R² est R¹, un groupe alcényle, ou de l'hydrogène, w est de 0 à 0,9, x est de 0 à 0,9, y est de 0 à 0,99, z est de 0 à 0,85, w+x+y+z=1, y+z/(w+x+y+z) est de 0,1 à 0,99, et w+x/(w+x+y+z) est de 0,01 à 0,9, à condition que ladite résine de silicone ait une moyenne d'au moins deux groupes alcényles liés au silicium par molécule.

5. Dispositif photovoltaïque à base de diséléniure de cuivre-indium (104) selon la revendication 3, dans lequel ladite résine de silicone est en outre définie comme résine de silicone modifiée au caoutchouc comprenant le produit de réaction de :
(A) une résine de silicone possédant la formule :
(R¹R²₂SiO_{1/2})_{w}(R²₂SiO_{2/2})ₓ(R²SiO_{3/2})_{y}(SiO_{4/2})_{z},
et
(D) au moins un caoutchouc de silicone sélectionné parmi des caoutchoucs possédant la formule :
R⁵R¹₂SiO(R¹R⁵SiO)_{c}SiR¹₂R⁵,
et
R¹R²₂SiO(R²₂SiO)_{d}SiR²₂R¹,
où R¹ est un groupe hydrocarbyle C₁ à C₁₀ ou un groupe hydrocarbyle substitué par halogène C₁ à C₁₀, tous les deux dépourvus d'insaturation aliphatique, R² est R¹, un groupe alcényle, ou de l'hydrogène, R⁵ est R¹ ou -H, w est de 0 à 0,9, x est de 0 à 0,9, y est de 0 à 0,99, z est de 0 à 0,85, w+x+y+z=1, y+z/(w+x+y+z) est de 0,1 à 0,99, et w+x/(w+x+y+z) est de 0,01 à 0,9, à condition que ladite résine de silicone ait une moyenne d'au moins deux groupes alcényles liés au silicium par molécule, (C) et (D) possèdent chacun une valeur de 4 à 1000,
en présence du catalyseur d'hydrosilylation (c) et,
facultativement, en présence d'un solvant organique, à condition que lorsque ladite résine de silicone (A) a des groupes alcényles liés au silicium, (D) ait des atomes d'hydrogène liés au silicium, et lorsque ladite résine de silicone (A) a des atomes d'hydrogène liés au silicium, (D) a des groupes alcényles liés au silicium.

6. Dispositif photovoltaïque à base de diséléniure de cuivre-indium (104) selon une quelconque des revendications 1 ou 2, dans lequel ladite composition de silicone est en outre définie comme composition de silicone durcissable par condensation comprenant :
(A²) une résine de silicone possédant au moins deux parmi un groupe hydroxy lié au silicium ou un groupe hydrolysable ;
facultativement, (B¹) un agent de réticulation possédant des groupes hydrolysables liés au silicium, et
facultativement, (C¹) une quantité catalytique d'un catalyseur de condensation.

7. Dispositif photovoltaïque à base de diséléniure de cuivre-indium (104) selon la revendication 6, dans lequel ladite résine de silicone présente la formule :
(R¹R⁶₂SiO_{1/2})_{w'}(R⁶₂SiO_{2/2})_{x'}(R⁶SiO_{3/2})_{y'}(SiO_{4/2})_{z'}
où R¹ est un groupe hydrocarbyle C₁ à C₁₀ ou un groupe hydrocarbyle substitué par halogène C₁ à C₁₀, tous les deux dépourvus d'insaturation aliphatique, R⁶ est R¹, -H, -OH, ou un groupe hydrolysable, w' est de 0 à 0,8, x' est de 0 à 0,95, y' est de 0 à 1, z' est de 0 à 0,99, w'+x'+y'+z'=1, à condition que ladite résine de silicone (A²) ait une moyenne d'au moins deux atomes d'hydrogène liés au silicium, groupes hydroxy, ou groupes hydrolysables par molécule.

8. Dispositif photovoltaïque à base de diséléniure de cuivre-indium (104) selon la revendication 6, dans lequel ladite résine de silicone présente la formule :
(R¹R⁶₂SiO_{½})_{w'}(R⁶₂SiO_{2/2})_{x'} (R⁶SiO_{3/2})_{y'}(SiO_{4/2})_{z'}
où R¹ est un groupe hydrocarbyle C₁ à C₁₀ ou un groupe hydrocarbyle substitué par halogène C₁ à C₁₀, tous les deux dépourvus d'insaturation aliphatique, R⁶ est R¹, -H, -OH, ou un groupe hydrolysable, w' est de 0 à 0,8, x' est de 0 à 0,95, y' est de 0 à 1, z' est de 0 à 0,99, w'+x'+y'+z'=1, à condition que la résine de silicone (A²) ait une moyenne d'au moins deux atomes d'hydrogène liés au silicium, groupes hydroxy, ou groupes hydrolysables par molécule à condition que la somme d'unités R¹SiO_{3/2} et unités SiO_{4/2} soit supérieure à zéro.

9. Dispositif photovoltaïque à base de diséléniure de cuivre-indium (104) selon une quelconque des revendications 1 ou 2, dans lequel ladite composition de silicone est en outre définie comme composition de silicone durcissable par condensation comprenant :
(A³) une résine de silicone modifiée au caoutchouc préparée en faisant réagir un composé d'organosilicium sélectionné parmi :
(i) une résine de silicone possédant la formule
(R¹R⁶₂SiO_{1/2})_{w'}(R⁶₂SiO_{2/2})_{x'}(R⁶SiO_{3/2})_{y'}(SiO_{4/2})_{z'},
(ii) des précurseurs hydrolysables de (i), et
(iii) un caoutchouc de silicone possédant la formule
R⁸₃SiO(R¹R⁸SiO)ₘSiR⁸₃ ;
en présence d'eau, un catalyseur de condensation, et un solvant organique,
où R¹ est un groupe hydrocarbyle C₁ à C₁₀ ou un groupe hydrocarbyle substitué par halogène C₁ à C₁₀, tous les deux dépourvus d'insaturation aliphatique, R⁶ est R¹, -H, -OH, ou un groupe hydrolysable, R⁸ est R¹ ou un groupe hydrolysable, m est de 2 à 1000, w' est de 0 à 0,8, x' est de 0 à 0,95, y' est de 0 à 1, z' est de 0 à 0,99, w'+x'+y'+z'=1 ;
facultativement, (B¹) un agent de réticulation possédant des groupes hydrolysables liés au silicium, et
facultativement, (C¹) une quantité catalytique d'un catalyseur de condensation.

10. Dispositif photovoltaïque à base de diséléniure de cuivre-indium (104) selon une quelconque des revendications 1 ou 2, dans lequel ladite composition de silicone est en outre définie comme composition de silicone durcissable par radicaux libres comprenant une résine de silicone possédant la formule :
(R¹R⁹₂SiO_{1/2})_{w}"(R⁹₂SiO_{2/2})ₓ"(R⁹SiO_{3/2})_{y}"(SiO_{4/2})_{z}"
où R¹ est un hydrocarbyle C₁ à C₁₀ ou hydrocarbyle substitué par halogène C₁ à C₁₀, tous les deux dépourvus d'insaturation aliphatique ; R⁹ est R¹, alcényle, ou alcynyle ; w" est de 0 à 0,99 ; x" est de 0 à 0,99 ; y" est de 0 à 0,99 ; z" est de 0 à 0,85 ; et w"+x"+y"+z"=1.

11. Dispositif photovoltaïque à base de diséléniure de cuivre-indium (104) selon une quelconque des revendications 1 ou 2, dans lequel ladite composition de silicone comprend des dihydrogènepolysiloxanes cycliques comprenant des unités H₂SiO_{2/2} et possédant un poids moléculaire moyen pondéral allant de 1500 à 1000000 et qui sont liquides à température ambiante.

12. Dispositif photovoltaïque à base de diséléniure de cuivre-indium (104) selon une quelconque des revendications 1 ou 2, dans lequel ladite composition de silicone comprend des hydrogènepolysiloxanes possédant une formule d'unité siloxane de [H₂SiO_{2/2}]ₓ"'[HSiO_{3/2}]_{y}"'[SiO_{4/2}]_{z}"'où x''', y''', et z''' représentent des fractions molaires, 0,12 ≤x''' < 1 ,0, 0 ≤y''' ≤0,88, 0 ≤z''' < 0,30, y''' et z''' ne sont pas simultanément 0, et x'''+y'''+z'''=1.

13. Dispositif photovoltaïque à base de diséléniure de cuivre-indium (104) selon l'une quelconque des revendications précédentes, dans lequel ledit substrat (106) comprend en outre une nano-charge.

14. Série (102) comprenant une pluralité desdits dispositifs photovoltaïques à base de diséléniure de cuivre-indium (104) selon l'une quelconque des revendications précédentes.

15. Procédé de préparation d'un dispositif à base de diséléniure de cuivre-indium (104) comprenant les étapes consistant à :
fournir un substrat (106) ;
former une couche d'absorption solaire à base de CIS (506) comprenant du cuivre, de l'indium, et sélénium sur le substrat (106)
**caractérisé en ce que** le substrat (106) est formé à partir d'une composition de silicone et comprend un renfort de fibre.
